# EUROPEAN PATENT APPLICATION

(11) **EP 4 750 289 A1**
(43) Date of publication of application: **27.05.2026**
(21) Application number: 25218421.3
(22) Date of filing: 25.11.2025
(51) Int. Cl.: H10K 59/121

(54) **DISPLAY PANEL AND ELECTRONIC APPARATUS INCLUDING THE DISPLAY PANEL**

(30) Priority: 26.11.2024 KR 20240171476; 24.03.2025 KR 20250037349
(71) Applicant: Samsung Display Co., Ltd., Yongin-si, Gyeonggi-do 17113 (KR)
(72) Inventor: Yang, Minki, 17113 Yongin-si, Gyeonggi-do (KR); Kim, Daehyun, 17113 Yongin-si, Gyeonggi-do (KR); Na, Jisu, 17113 Yongin-si, Gyeonggi-do (KR); Park, Hyunae, 17113 Yongin-si, Gyeonggi-do (KR); Jin, Changkyu, 17113 Yongin-si, Gyeonggi-do (KR)
(74) Representative: Gulde & Partner

(57) **Abstract**

Provided are a display panel capable of displaying high-quality images and an electronic apparatus including the display panel, the display panel including a substrate, a first capacitor electrode disposed over the substrate, a second capacitor electrode which is disposed over the first capacitor electrode, overlaps the first capacitor electrode when viewed in a direction perpendicular to the substrate, and has a first indented portion which is indented inward at a side of the second capacitor electrode and exposes a portion of the first capacitor electrode when viewed in the direction perpendicular to the substrate, and a first connection electrode disposed over the second capacitor electrode and connected to the first capacitor electrode through a contact hole located in the first indented portion.

## Description

This application claims priority to Korean Patent Application No. 10-2024-0171476, filed on November 26, 2024, and Korean Patent Application No. 10-2025-0037349, filed on March 24, 2025, and all the benefits accruing therefrom under 35 U.S.C. §119, the contents of which in their entirety are herein incorporated by reference.

### BACKGROUND

### 1. Field

One or more embodiments relate to a display panel and an electronic apparatus including the display panel, and more particularly, to a display panel capable of displaying high-quality images and an electronic apparatus including the display panel.

### 2. Description of the Related Art

Display panels have been used in various electronic apparatuses. In order to display high-quality images with increased resolution, pixel sizes are decreased, and thus, it may be desired to place a variety of electronic components in a small area.

### SUMMARY

In the case of a display panel and an electronic apparatus including the display panel, according to the related art, high-quality images cannot be displayed because, as a size of a pixel decreases, a size of electronic components included in the pixel decreases and performance of the electronic components deteriorates.

One or more embodiments include a display panel capable of displaying high-quality images and an electronic apparatus including the display panel. However, the embodiments are examples and do not limit the scope of the disclosure.

Additional aspects will be set forth in part in the description which follows and, in part, will be apparent from the description, or may be learned by practice of the presented embodiments of the disclosure.

According to one or more embodiments, a display panel includes a substrate, a first capacitor electrode disposed over the substrate, a second capacitor electrode which is disposed over the first capacitor electrode, overlaps the first capacitor electrode when viewed in a direction perpendicular to the substrate, and has a first indented portion which is indented inward at a side of the second capacitor electrode and exposes a portion of the first capacitor electrode when viewed in the direction perpendicular to the substrate, and a first connection electrode disposed over the second capacitor electrode and connected to the first capacitor electrode through a contact hole located in the first indented portion. An advantage of this configuration is that by arranging the contact between the first connection electrode and the first capacitor electrode in an indented portion of the second capacitor electrode, an efficient electrical connection can be achieved without unnecessarily increasing the area of the second capacitor electrode. As a result, a more compact capacitor structure can be realized, which in turn allows for a higher pixel density of the display panel. Since the overlap between the first and second capacitor electrodes is largely maintained, the capacitance of the capacitor is not significantly reduced. Thus, good electrical performance is preserved while at the same time optimized area usage is achieved.

The first capacitor electrode may have a first protrusion which, when viewed in the direction perpendicular to the substrate, protrudes outside the first indented portion, at the portion of the first capacitor electrode exposed by the first indented portion. This means that the first capacitor electrode extends laterally beyond the boundary defined by the indentation of the second capacitor electrode. In this arrangement, the protruding part of the first capacitor electrode becomes accessible within the recessed area of the second electrode, which is used for establishing an electrical connection via a contact hole. A technical advantage of this feature is that the protrusion increases the available surface area of the first capacitor electrode at the contact interface without enlarging the overall capacitor footprint. This facilitates a more reliable and robust electrical contact to the first connection electrode, as a larger exposed electrode area improves the manufacturing tolerance during contact hole formation and metal deposition. It also reduces contact resistance by providing more physical contact area for electrical conduction. As a result, the electrical stability and operational reliability of the display panel can be improved.

When viewed in the direction perpendicular to the substrate, the first connection electrode may overlap the first protrusion and extend in a direction away from the first indented portion. This layout ensures that the vertical connection between the first capacitor electrode and the connection electrode is formed at the protrusion, while the connection electrode continues its path beyond this region. A technical advantage of this feature is that it enables a structurally and electrically optimized routing of the connection electrode. By overlapping the protrusion, the connection electrode can establish a reliable electrical contact while minimizing the footprint required for this contact. The extension of the electrode away from the indented area allows for flexible integration into the overall circuit design of the display panel, enabling it to be connected to additional components or signal lines without interfering with the capacitor structure.

The display panel may further include a third capacitor electrode which is disposed over the second capacitor electrode, overlaps the second capacitor electrode when viewed in the direction perpendicular to the substrate, and has a second indented portion which is indented inward at a side of the third capacitor electrode and exposes the first indented portion when viewed in the direction perpendicular to the substrate, and the first connection electrode may be disposed over the third capacitor electrode. This third electrode forms another overlapping capacitor configuration and is patterned in such a way that an indentation in its edge aligns with the indentation of the second electrode, thereby exposing the area where the first connection electrode contacts the first capacitor electrode. A technical advantage of this arrangement is that it enables the stacking of additional capacitor electrodes to increase the effective capacitance within the same pixel area. By having the third electrode overlap with the second electrode, another capacitor structure is formed, thereby contributing to the overall storage capacity available to the pixel. This is particularly beneficial for display panels requiring high capacitance for stable pixel operation, such as high-refresh-rate or high-resolution displays.

When viewed in the direction perpendicular to the substrate, the first indented portion may be located within the second indented portion. This ensures that the area for forming the electrical contact to the first capacitor electrode remains unobstructed, even with multiple overlapping electrode layers present. A technical advantage of this feature is that it enables precise vertical alignment of multiple electrode layers while maintaining clear access to lower-layer contact areas. By placing the first indented portion within the second indented portion, a clean vertical clearance path is created through the stacked capacitor structure. This ensures that the connection electrode can reliably reach the first capacitor electrode without interference from either the second or third capacitor electrodes.

When viewed in the direction perpendicular to the substrate, each of the first capacitor electrode and the second capacitor electrode may have an isolated shape, and the third capacitor electrode may have a shape extending in a first direction. A technical advantage of having the first and second capacitor electrodes in isolated shapes is that each capacitor is spatially confined to its respective pixel area, thereby minimizing cross-talk between adjacent pixels. This isolation ensures that each pixel maintains its individual storage characteristics, contributing to improved image stability and reduced signal interference in high-resolution displays.

Each of the first capacitor electrode and the second capacitor electrode may be located within one pixel, and the third capacitor electrode may be integrally formed as a single indivisible body throughout a plurality of pixels. A technical advantage of confining the first and second capacitor electrodes within individual pixels is the provision of localized capacitance tailored to each pixel's driving requirements. This supports independent pixel operation and improves the ability of each pixel to hold its voltage level over time, contributing to image stability, particularly in high-refresh or low-leakage display modes.

The display panel may further include a power line disposed over the third capacitor electrode and extending in a second direction crossing the first direction, and the third capacitor electrode and the power line may be electrically connected to each other through a contact hole. A technical advantage of this configuration is the ability to implement a vertical electrical connection between the power distribution layer and the third capacitor electrode without requiring lateral routing space within the pixel area. By placing the power line above the third electrode and connecting them through a contact hole, the layout remains compact and efficient, which is crucial for high-resolution display panels where routing density is a major constraint.

The first connection electrode and the power line may include a same material and may be disposed on a same insulating layer. A technical advantage of this configuration is process simplification. By using the same material and layer for both the first connection electrode and the power line, the number of photolithographic and deposition steps is reduced, which lowers manufacturing complexity and cost. Fewer steps also reduce the likelihood of layer misalignment and improve overall yield.

The third capacitor electrode may have a third indented portion which, when viewed in the direction perpendicular to the substrate, is indented inward at another side of the third capacitor electrode and exposes a portion of the second capacitor electrode, and the display panel may further include a second connection electrode disposed over the third capacitor electrode and connected to the second capacitor electrode through a contact hole located in the third indented portion. A technical advantage of this feature is that it enables efficient vertical routing to the second capacitor electrode without requiring the third electrode to be removed or heavily patterned over the contact area. By providing an inward indentation that exposes the second electrode, the design offers a localized window for a contact hole, simplifying the formation of the vertical interconnect.

The second capacitor electrode may have a second protrusion which protrudes outside the third indented portion at the portion of the second capacitor electrode exposed by the third indented portion. A technical advantage of this feature is the improved reliability and robustness of the electrical contact between the second capacitor electrode and the second connection electrode. The protruding portion creates a wider and more accessible contact area within the indentation, which facilitates precise alignment of the contact hole and enhances the metal coverage during deposition. This, in turn, reduces contact resistance and mitigates risks of poor electrical connection due to manufacturing tolerances or layer misalignment.

When viewed in the direction perpendicular to the substrate, the second connection electrode may overlap the second protrusion and may extend in a direction away from the third indented portion. A technical advantage of this configuration is the enhanced reliability and manufacturability of the vertical connection to the second capacitor electrode. The overlap with the protruding region provides a generous contact area, improving metal coverage and reducing the likelihood of high contact resistance or electrical failure due to misalignment. This leads to improved operational stability and production yield.

The display panel may further include a semiconductor layer interposed between the substrate and the first capacitor electrode and including a first portion and a second portion, a data line disposed over the semiconductor layer, extending in a second direction, and electrically connected to the first portion through a contact hole, and a second connection electrode disposed over the second capacitor electrode and electrically connecting the second capacitor electrode to the second portion, wherein the second capacitor electrode may include a third protrusion which, when viewed in the direction perpendicular to the substrate, protrudes between the first portion and the second portion. A technical advantage of this arrangement is that the second capacitor electrode is spatially aligned with the active region of the TFT, ensuring efficient use of pixel area. The protrusion allows for maximized overlap with the underlying semiconductor while avoiding electrical interference with the contact regions. This promotes compact pixel design and improved capacitance per area.

The display panel may further include a third capacitor electrode which is disposed over the second capacitor electrode, overlaps the second capacitor electrode when viewed in the direction perpendicular to the substrate, and has a fourth protrusion which protrudes and overlaps the third protrusion when viewed in the direction perpendicular to the substrate. This structural alignment of the fourth protrusion with the third protrusion creates an overlapping capacitor region that is specifically positioned over the active semiconductor area of the thin-film transistor. A technical advantage of this arrangement is that it increases the effective capacitance in the region where signal storage is most critical, which isdirectly over the channel area of the transistor. The aligned protrusions ensure that the capacitor electrodes are efficiently used in the limited pixel area, boosting storage capacity without increasing pixel dimensions.

The display panel may further include a power line disposed over the third capacitor electrode and extending in a second direction crossing a first direction in which the third capacitor electrode extends, and the third capacitor electrode and the power line may be electrically connected to each other through a contact hole. A technical advantage of this configuration is the efficient integration of vertical interconnects within a multilayer electrode structure, enabling the third capacitor electrode to be biased or supplied with a reference voltage without needing lateral routing within the active pixel region. The ability to route the power line in a direction crossing the extension of the third electrode supports a grid-like power distribution architecture, which is essential for uniform voltage delivery across the display panel.

According to one or more embodiments, an electronic apparatus includes a processor and a display panel controlled by the processor, wherein the display panel includes a substrate, a first capacitor electrode disposed over the substrate, a second capacitor electrode which is disposed over the first capacitor electrode, overlaps the first capacitor electrode when viewed in a direction perpendicular to the substrate, and has a first indented portion which is indented inward at a side of the second capacitor electrode and exposes a portion of the first capacitor electrode when viewed in the direction perpendicular to the substrate, and a first connection electrode disposed over the second capacitor electrode and connected to the first capacitor electrode through a contact hole located in the first indented portion. The display panel may be designed in accordance with the aforementioned display panel. The previous explanations regarding the display panel also apply to the electronic apparatus.

The first capacitor electrode may have a first protrusion which, when viewed in the direction perpendicular to the substrate, protrudes outside the first indented portion, at the portion of the first capacitor electrode exposed by the first indented portion.

The electronic apparatus may further include a third capacitor electrode which is disposed over the second capacitor electrode, overlaps the second capacitor electrode when viewed in the direction perpendicular to the substrate, has a second indented portion which is indented inward at a side of the third capacitor electrode and exposes the first indented portion when viewed in the direction perpendicular to the substrate, and has a third indented portion which is indented inward at another side of the third capacitor electrode and exposes a portion of the second capacitor electrode when viewed in the direction perpendicular to the substrate, and a second connection electrode disposed over the third capacitor electrode and connected to the second capacitor electrode through a contact hole located in the third indented portion, wherein the first connection electrode and the second connection electrode may be disposed on a same insulating layer.

The second capacitor electrode may have a second protrusion which protrudes outside the third indented portion at the portion of the second capacitor electrode exposed by the third indented portion.

The electronic apparatus may further include a semiconductor layer interposed between the substrate and the first capacitor electrode and including a first portion and a second portion, a data line disposed over the semiconductor layer, extending in a second direction, and electrically connected to the first portion through a contact hole, a second connection electrode disposed over the second capacitor electrode and electrically connecting the second capacitor electrode to the second portion, and a third capacitor electrode disposed over the second capacitor electrode and overlapping the second capacitor electrode when viewed in the direction perpendicular to the substrate, wherein, when viewed in the direction perpendicular to the substrate, the second capacitor electrode may include a third protrusion protruding between the first portion and the second portion, and the third capacitor electrode may include a fourth protrusion which protrudes and overlaps the third protrusion.

Other aspects, features, and advantages other than those described herein will become apparent from the following detailed description, the appended claims, and the accompanying drawings.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a block diagram schematically illustrating an electronic apparatus according to an embodiment;
FIG. 2 illustrates schematic diagrams of electronic apparatuses according to embodiments;
FIG. 3 is a schematic diagram illustrating a case where electronic apparatuses according to embodiments are wearable electronic apparatuses;
FIG. 4 is a schematic diagram illustrating a case where an electronic apparatus according to an embodiment is a vehicle electronic apparatus;
FIG. 5 is a schematic plan view of a display module including a display panel according to an embodiment;
FIG. 6 is a schematic side view of the display module of FIG. 5;
FIG. 7 is a schematic plan view of the display module of FIG. 5;
FIG. 8 is an equivalent circuit diagram illustrating a pixel circuit electrically connected to a display element included in the display module of FIG. 7;
FIG. 9 is a waveform diagram illustrating an electrical signal applicable to the pixel circuit of FIG. 8;
FIG. 10 is a layout diagram schematically illustrating locations of transistors, a capacitor, and other components in pixels of the display module of FIG. 7;
FIGS. 11 to 15 are layout diagrams schematically illustrating, layer by layer, components such as transistors and capacitors illustrated in FIG. 10;
FIG. 16 is a layout diagram illustrating pixel electrodes that may be electrically connected to the pixel circuits of FIG. 10;
FIG. 17 is a cross-sectional view schematically illustrating a cross-section of the display module taken along line A-A' of FIG. 10;
FIG. 18 is an equivalent circuit diagram illustrating a pixel circuit electrically connected to a display element included in a display module according to an embodiment; and
FIG. 19 is an equivalent circuit diagram illustrating a pixel circuit electrically connected to a display element included in a display module according to an embodiment.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described herein, by referring to the figures, to explain aspects of the present description. As used herein, the term "and/or" includes any and all combinations of one or more of the associated listed items. Throughout the disclosure, the expression "at least one of a, b or c" indicates only a, only b, only c, both a and b, both a and c, both b and c, all of a, b, and c, or variations thereof.

As various modifications may be applied and numerous embodiments may be implemented, particular embodiments will be illustrated in the drawings and described in detail in the written description. Effects and features, and methods for achieving them will be clarified with reference to embodiments described herein in detail with reference to the drawings. However, the embodiments may have different forms and should not be construed as being limited to the descriptions set forth herein.

Hereinafter, the embodiments will now be described in detail with reference to the accompanying drawings. In an example in which described with reference to the drawings, identical or corresponding elements will be given the same reference numerals, and redundant description of these elements will be omitted.

In the following embodiments, it will be understood that when an element, such as, for example, a layer, film, region, or plate, is referred to as being "on" another element, the element may be "directly on" the other element or indirectly on the other element with intervening elements therebetween. In some aspects, sizes of elements in the drawings may be exaggerated or reduced for convenience of descriptions. For example, because sizes and thicknesses of elements in the drawings are arbitrarily illustrated for convenience of descriptions, the following embodiments are not limited thereto.

In the following embodiments, the x-axis, the y-axis, and the z-axis are not limited to three axes of the rectangular coordinate system, and may be interpreted in a broader sense. For example, the x-axis, y-axis, and z-axis may be orthogonal to each other, but may refer to different directions that are not orthogonal to each other.

In the following embodiments, while terms such as, for example, "first" and "second" are used to describe various elements, these elements are not limited by these terms. These terms are used to distinguish one element from another element.

It will be understood that terms "comprise," "include," and "have" used herein specify the presence of stated features or elements, but do not preclude the presence or addition of one or more other features or elements.

The term "substantially," as used herein, means approximately or actually. The term "substantially equal" means approximately or actually equal. The term "substantially the same" means approximately or actually the same. The term "substantially perpendicular" means approximately or actually perpendicular. The term "substantially parallel" means approximately or actually parallel. The term "substantially identical" means approximately or actually identical.

As used herein, the expression such as "A and/or B" indicates A, B, or A and B. In some aspects, the expression such as "at least one of A and B" indicates A, B, or A and B.

In the following embodiments, it will be understood that when a layer, region, or element is referred to as being "connected to" or "coupled to" another layer, region, or element, it may be directly or indirectly connected or coupled to the other layer, region, or element. That is, for example, intervening layers, regions, or elements may be present. For example, as used herein, when a layer, region, or element is referred to as being electrically connected to another element, it may be directly electrically connected to the other layer, region, or element or indirectly electrically connected to the other layer, region, or element via intervening layers, regions, or elements.

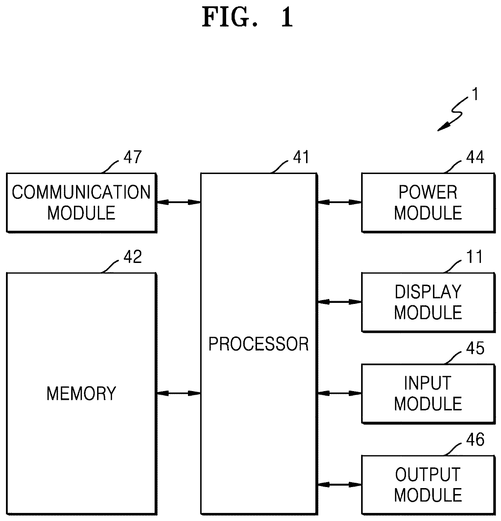

FIG. 1 is a schematic block diagram of an electronic apparatus 1 according to an embodiment. According to the present embodiment, the electronic apparatus 1 may include a display apparatus and modules having additional functions in addition to a display module 11.

As illustrated in FIG. 1, according to the present embodiment, the electronic apparatus 1 may include the display module 11, a processor 41, a memory 42, a power module 44, an input module 45, an output module 46, and a communication module 47.

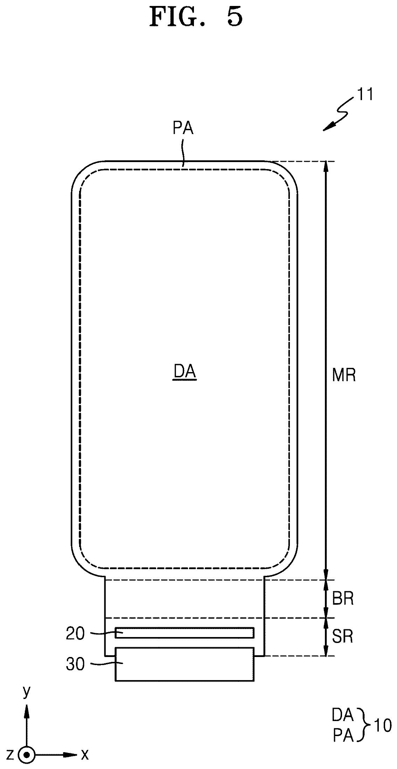

The display module 11 may include a display panel 10 (see FIG. 5) as described herein. For example, the display module 11 may include the display panel 10 and a data driver 20 (see FIG. 5) mounted thereon. The display panel 10 is described herein.

The processor 41 may control most of the components of the electronic apparatus 1. For example, the processor 41 may output digital video data to the display module 11 such that the display module 11 may display an image and may receive input data from the input module 45 such that a function according to the input data may be performed in the electronic apparatus 1. The processor 41 may include at least one of a central processing unit (CPU), an application processor (AP), a graphics processing unit (GPU), a communication processor (CP), and an image signal processor (ISP).

When applicable in accordance with one or more embodiments of the present disclosure, the processor 41 may be divided into two or more processors from a functional or structural point of view. For example, the processor 41 may include a main processor in the form of a first driving chip including a CPU, and an auxiliary processor in the form of a second driving chip which is a portion of the display module 11. The auxiliary processor in the form of the second driving chip may include a controller configured to receive an image signal from the main processor and process the image signal according to interface specifications of the display panel 10 included in the display module 11.

The memory 42 may include at least one of a nonvolatile memory and a volatile memory. The memory 42 may store data information supportive of the operation of the processor 41 or the display module 11. In an example in which the processor 41 executes an application stored in the memory 42, an input control signal and/or a data signal for an image may be transmitted to the display module 11, and the display module 11 may output image information by processing the received signal.

The power module 44 may include a power supply module, such as, for example, a power adapter or a battery apparatus, and a power conversion module configured to generate power for the operation of the electronic apparatus 1 by converting power supplied by the power supply module. Power conversion performed by the power conversion module may include direct current (DC)-DC conversion, alternating current (AC)-DC conversion, and DC-AC conversion. However, one or more embodiments are not limited thereto.

The input module 45 may provide input information to the processor 41 and/or the display module 11. The input module 45 may include a physical button, a keyboard, and a microphone, as well as various sensor modules. Examples of the sensor modules may include a touch sensor, a pressure sensor, a distance sensor, a position sensor, a digitizer, a motion recognition sensor, a camera sensor, a light reception sensor, a photoelectric conversion sensor, and/or a temperature sensor. In some aspects, the sensor modules may include biosensors, such as, for example, a blood pressure sensor, a blood glucose sensor, an electrocardiogram sensor, and/or a heart rate sensor.

The output module 46 may receive information other than the image received from the processor 41 and provide the information to a user. The output module 46 may include, for example, an acoustic module, a haptic module, and/or a light-emitting module. In some aspects, the output module 46 may include a unique functional module of the electronic apparatus 1, such as, for example, a cooling module of a refrigerator.

For reference, the display module 11 may also perform an output function. For example, the display panel 10 included in the display module 11 may display (output) information processed by the electronic apparatus 1. For example, the display panel 10 may be configured to display execution screen information of an application driven in the electronic apparatus 1, or to display user interface (UI) or graphic user interface (GUI) information according to the execution screen information. The display panel 10 may include a display layer configured to display an image, and a touch screen layer configured to detect a touch input from the user. Accordingly, the display panel 10 may function as a portion of the input module 45 configured to provide an input interface between the electronic apparatus 1 and the user and may also function as a portion of the output module 46 configured to provide an output interface between the electronic apparatus 1 and the user.

The communication module 47 is a module configured to transmit and receive information between the electronic apparatus 1 and an external apparatus and may include a receiver and a transmitter. The communication module 47 may include various wireless communication modules, such as, for example, a mobile communication module, a broadcast reception module, a wireless Internet module, a short-range communication module, a wireless-fidelity (Wi-Fi) module, and/or a Bluetooth module, or various wired communication modules.

The electronic apparatus 1 illustrated in FIG. 1 is an example, and for example, a display apparatus without a communication function may not include the communication module 47. In some aspects, for example, when the electronic apparatus 1 includes a display apparatus, at least one of the components of the electronic apparatus 1 described herein may be included in the display apparatus. In some aspects, some of individual modules functionally included in a single module may be included in the display apparatus, and others thereof may be included in the electronic apparatus 1 separate from the display apparatus. For example, the display apparatus may include the display module 11, while the processor 41, the memory 42, and the power module 44 may be components of the electronic apparatus 1 other than the display apparatus. Alternatively, various modifications are possible. The display apparatus may include the display module 11 and the power module 44, and the power module 44 may supply power to the components of the electronic apparatus 1, such as, for example, the processor 41 and the memory 42.

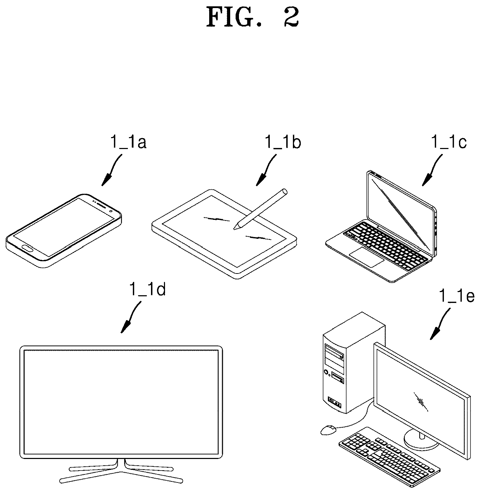

FIG. 2 illustrates schematic diagrams of electronic apparatuses 1 according to embodiments. In FIG. 2, a smartphone 1_1a, a tablet personal computer (PC) 1_1b, a laptop computer 1_1c, a television (TV) 1_1d, and a desktop monitor 1_1e are illustrated as examples of the electronic apparatus 1.

The smartphone 1_1a may include the processor 41, the memory 42, the power module 44, and the display module 11, as well as the input module 45, such as, for example, a touch sensor, and the communication module 47. The smartphone 1_1a may process information received via the communication module 47 or another input module and display the information via the display module 11.

Similar to the smartphone 1_1a, each of the tablet PC 1_1b, the laptop computer 1_1c, the TV 1_1d, and/or the desktop monitor 1_1e may include the display module 11 and the input module 45, and in some cases, may also include the communication module 47.

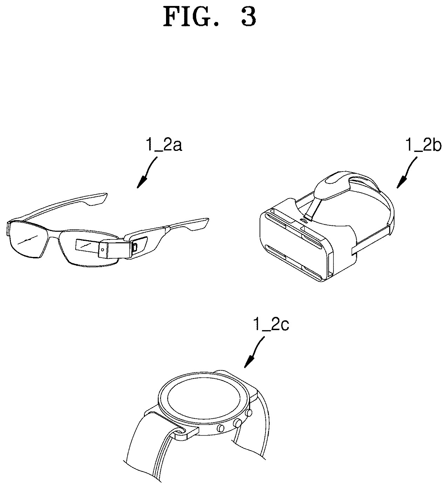

FIG. 3 is a schematic diagram illustrating a case where the electronic apparatuses 1 are wearable electronic apparatuses, according to embodiments. In FIG. 3, smart glasses 1_2a, a head mount display 1_2b, and a smart watch 1_2c are illustrated as examples of the electronic apparatus 1.

The smart glasses 1_2a and the head mount display 1_2b may each include the display module 11 configured to display an image, and a reflector configured to reflect a display surface that displays the image and provide the same to a user's eyes. The user may experience virtual reality or augmented reality by using the electronic apparatus 1.

The smart watch 1_2c may include a biometric sensor as the input module 45 and may provide biometric information identified by the biometric sensor to the user via the display module 11.

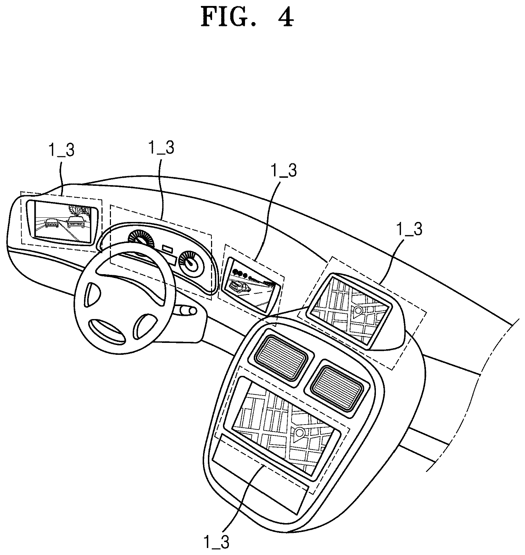

FIG. 4 is a schematic diagram illustrating a case where the electronic apparatus 1 is a vehicle electronic apparatus 1_3, according to embodiments. As illustrated in FIG. 4, the vehicle electronic apparatus 1_3 may include a display of a cluster of a vehicle, a display of an instrument panel of a vehicle, a center information display (CID) of a center fascia or a dashboard of a vehicle, or a room mirror display replacing a side mirror of a vehicle.

However, the electronic apparatus 1 according to one or more embodiments is not limited to the above description. For example, according to an embodiment, the electronic apparatus 1 may include not only apparatuses mainly used as displays, such as, for example, billboards, electronic boards, and/or game consoles, but also various home appliances configured to display information via the display module 11, such as, for example, refrigerators, washing machines, drying machines, air conditioners, and/or robot vacuum cleaners. In some aspects, when the display module 11 has a function of transmitting light, the electronic apparatus 1 may include a smart window or a transparent display apparatus configured to display a background and a display image together. However, the electronic apparatus 1 according to one or more embodiments is not limited thereto, and the electronic apparatus 1 including the display panel 10 to be described herein may fall within the scope of the one or more embodiments.

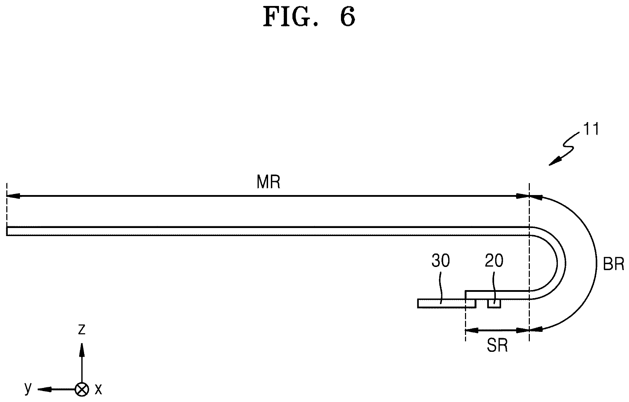

FIG. 5 is a schematic plan view of the display module 11 including the display panel 10, according to an embodiment. FIG. 6 is a schematic side view of the display module 11 of FIG. 5. The display module 11 included in the electronic apparatus 1 described herein may include the display panel 10 as illustrated in FIGS. 5 and 6. This applies to the following embodiments and modifications thereof.

In a plan view, the display panel 10 may appear to have an approximately rectangular shape. For example, as illustrated in FIG. 5, the display panel 10 may have an approximately rectangular shape having short sides in a first direction (e.g., an x-axis direction) and long sides in a second direction (e.g., a y-axis direction) on a xy-plane. In this case, an edge where a short side in the first direction (x-axis direction) and a long side in the second direction (y-axis direction) meet may form a right angle, or may have a round shape with a certain curvature. However, in the plan view, the display panel 10 may have a polygonal shape other than the rectangular shape, or may have an elliptical shape or an irregular shape.

The display panel 10 may include a display area DA and a peripheral area PA outside the display area DA. The display area DA may be an area where an image is displayed, and a plurality of pixels may be located in the display area DA. The display area DA may have other various shapes, such as, for example, a circular shape, an elliptical shape, a polygonal shape, or a specific figure shape. FIG. 5 illustrates that the display area DA has an approximately rectangular shape with round edges.

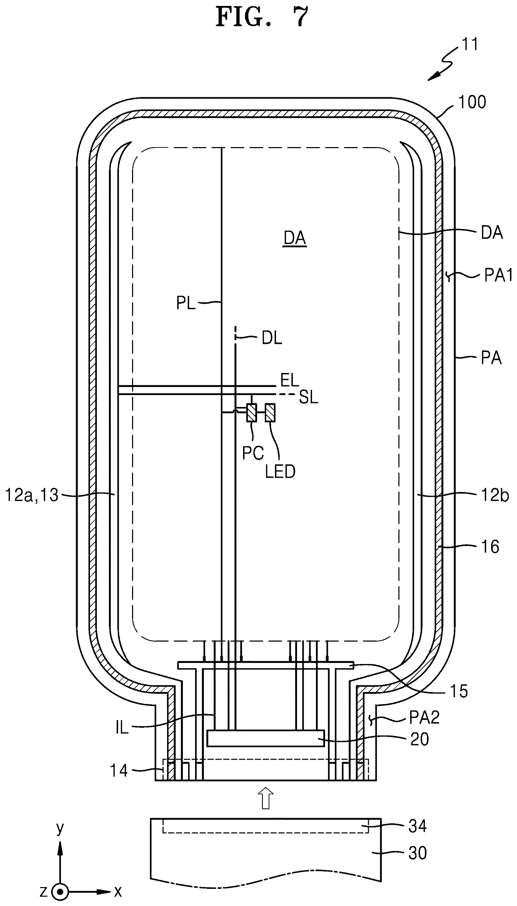

A shape of the plane of the display panel 10 illustrated in FIG. 5 may be substantially identical to a shape of a substrate 100 (see FIG. 7) included in the display panel 10. In an example in which the display panel 10 includes the display area DA and the peripheral area PA outside the display area DA, it may be understood that the substrate 100 may include the display area DA and the peripheral area PA outside the display area DA. Hereinbelow, for convenience of descriptions, it is described that the substrate 100 includes the display area DA and the peripheral area PA.

The display panel 10 may include a main region MR, a bending region BR outside the main region MR, and a subregion SR apart from the main region MR with the bending region BR therebetween. The main region MR may be located on one side of the bending region BR, and the subregion SR may be located on the other side of the bending region BR. As illustrated in FIG. 6, the display panel 10 may be bent in the bending region BR, and when viewed in a third direction (z-axis direction), at least a portion of the subregion SR may overlap the main region MR.

FIG. 6 illustrates that the display panel 10 is bent, but one or more embodiments are not limited thereto. For example, the display panel 10 may include a foldable display panel, and in this case, the display panel 10 may be bent in the display area DA with respect to a bending axis crossing the display area DA. However, when applicable or desired in accordance with one or more embodiments of the present disclosure, the display panel 10 may not be bent. The subregion SR may include a non-display area.

As described herein, the display panel 10 may include a rigid display panel that has strength and thus is not easily bent, or a flexible display panel that has flexibility and thus is bendable, foldable, or rollable. For example, the display panel 10 may include a foldable display panel that may be folded or unfolded, a curved display panel having a curved display surface, a bent display panel in which areas other than a display surface are bent, a rollable display panel that may be rolled or unrolled, or a stretchable display panel that may be stretched.

The display module 11 including the display panel 10 may include the data driver 20 mounted in the subregion SR of the display panel 10. The data driver 20 may be disposed on the display panel 10 in the form of an integrated circuit (IC). For example, the data driver 20 may be a data driving IC configured to generate data signals. As described herein, the data driver 20 may include an auxiliary processor in the form of a second driving chip, and may be a portion of the processor 41.

A display circuit board 30 may be attached to an end of the subregion SR of the display panel 10. For example, when applicable or desired in accordance with one or more embodiments of the present disclosure, the display module 11 may include the display circuit board 30. The display circuit board 30 may be electrically connected to the data driver 20 via a pad of the subregion SR of the display panel 10.

FIG. 7 is a schematic plan view of the display module 11 of FIG. 5. As illustrated in FIG. 7, the display panel 10 included in the display module 11 may include the substrate 100. Various components included in the display panel 10 may be disposed over the substrate 100.

The substrate 100 may include glass, ceramic, a metal, or polymer resin. The substrate 100 may include polymer resin, such as, for example, polyethersulfone, polyacrylate, polyetherimide, polyethylene naphthalate, polyethylene terephthalate, polyphenylene sulfide, polyarylate, polyimide, polycarbonate, or cellulose acetate propionate. The substrate 100 may have a multilayer structure including two layers each including the polymer resin and an inorganic layer therebetween. Alternatively, the substrate 100 may have a structure in which a layer including the polymer resin and an inorganic layer are alternately stacked. The inorganic layer may include silicon oxide, silicon nitride, or silicon oxynitride.

The pixels may be disposed in the display area DA, and the display area DA may display images using light emitted from the pixels. Each pixel may include a display element, such as, for example, a light-emitting diode LED, and the display element may be electrically connected to a pixel circuit PC. The pixel circuit PC and the light-emitting diode LED may be disposed in the display area DA. In FIG. 7, for convenience, the pixel circuit PC and the light-emitting diode LED are illustrated as being positioned side by side; however, the pixel circuit PC and the light-emitting diode LED may overlap at least partially. As an example, the light-emitting diode LED may be disposed on the pixel circuit PC.

A gate driving circuit, a pad 14, a power supply line 15, and a common voltage supply line 16 may be disposed in the peripheral area PA. The gate driving circuit may include, for example, a first scan driving circuit 12a, a second scan driving circuit 12b, and/or an emission control driving circuit 13.

The first scan driving circuit 12a may provide a scan signal to the pixel circuit PC through a gate line SL. The second scan driving circuit 12b may be arranged on the opposite side from the first scan driving circuit 12a with the display area DA therebetween. Some of the pixel circuits PC disposed in the display area DA may be electrically connected to the first scan driving circuit 12a, and the remaining ones may be connected to the second scan driving circuit 12b. In another embodiment, the second scan driving circuit 12b may be omitted.

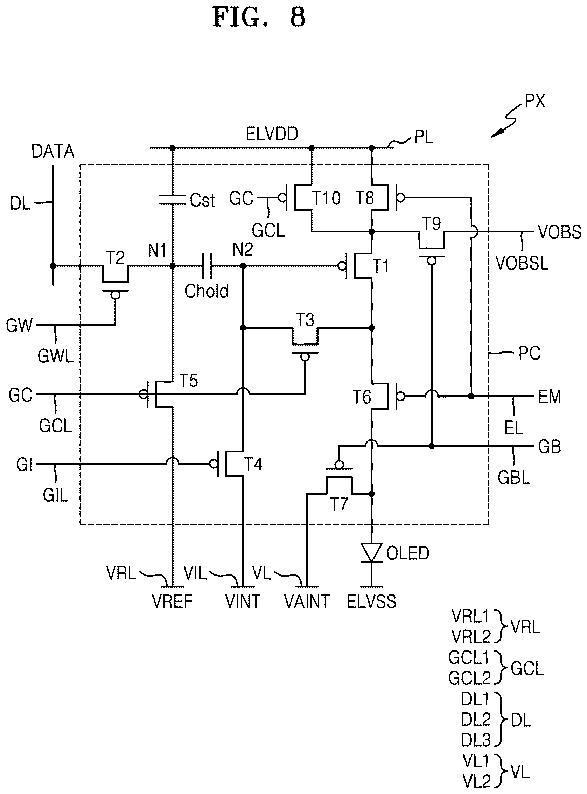

The emission control driving circuit 13 may be disposed on the first scan driving circuit 12a side. The emission control driving circuit 13 may provide an emission control signal EM to the pixel PX (see FIG. 8) through an emission control line EL. In FIG. 7, the emission control driving circuit 13 is disposed on one side of the display area DA, without being disposed on other sides of the display area DA. However, one or more embodiments are not limited thereto. For example, the display panel 10 may include the emission control driving circuits 13 disposed on one side and the other side of the display area DA. Alternatively, the display panel 10 may include the first scan driving circuit 12a arranged on one side of the display area DA, and the emission control driving circuit 13 arranged on the other side of the display area DA.

The peripheral area PA may include a first peripheral area PA1 surrounding at least a portion of the display area DA, and a second peripheral area PA2 located at a side of the display area DA and extending in a first direction (x-axis direction). A width of the second peripheral area PA2 in the first direction (x-axis direction) may be smaller than a width of the display area DA. Through this structure, at least a portion of the second peripheral area PA2 may be easily bent.

The pad 14 may be disposed in the second peripheral area PA2 of the substrate 100. The pad 14 may be exposed by not being covered by an insulating layer, and may be electrically connected to the display circuit board 30. A pad 34 of the display circuit board 30 may be electrically connected to the pad 14 of the display panel 10.

The display circuit board 30 is configured to transmit signals of a controller or power to the display panel 10. The display circuit board 30 may be, for example, a printed circuit board or a flexible printed circuit board. Control signals generated by the controller may be transmitted to the gate driving circuit through the display circuit board 30. In some aspects, the controller may provide a driving voltage ELVDD and a common voltage ELVSS to the power supply line 15 and the common voltage supply line 16, respectively. The driving voltage ELVDD may be provided to each pixel circuit PC through a driving voltage line (or power line) PL connected to the power supply line 15, and the common voltage ELVSS may be provided to a common electrode of the light-emitting diode LED connected to the common voltage supply line 16. The power supply line 15 may extend in the first direction (x axis direction). The common voltage supply line 16 may have a loop shape having one open side and partially surround the display area DA.

A data signal of the data driver 20 may be transmitted to the pixel circuit PC through an input line IL and a data line DL electrically connected to the input line IL.

FIG. 8 is an equivalent circuit diagram illustrating the pixel circuit PC which may be electrically connected to the display element, such as, for example, the light emitting diode LED, included in the display panel 10 of the display module 11 of FIG. 7.

The display panel 10 may have a plurality of pixels PX in the display area DA. Each of pixels PX may include the display element, such as, for example, the light-emitting diode LED, and the pixel circuit PC which may be electrically connected to the display element. FIG. 8 illustrates that the pixel PX includes an organic light-emitting diode OLED as the display element. The pixel circuit PC illustrated in FIG. 8 may be a pixel circuit PC included in any one pixel PX located in the N^{th} row of the display area DA.

The pixel circuit PC may include a plurality of transistors T1, T2, T3, T4, T5, T6, T7, T8, T9, and T10 and a plurality of capacitors Cst and Chold as illustrated in FIG. 8. In one or more embodiments, the number of transistors and the number of capacitors included in the pixel circuit PC are not limited to those illustrated in FIG. 8 and may be changed. For example, the pixel circuit PC may include seven transistors and one capacitor, the pixel circuit PC may include seven transistors and two capacitors, or the pixel circuit PC may include nine transistors and two capacitors. Hereinafter, for convenience of descriptions, it is described that the pixel circuit PC includes ten transistors T1, T2, T3, T4, T5, T6, T7, T8, T9, and T10 and two capacitors Cst and Chold as illustrated in FIG. 8.

The pixel circuit PC may be electrically connected to a first scan line GWL configured to transmit a first scan signal GW, a second scan line GCL configured to transmit a second scan signal GC, a third scan line GIL configured to transmit a third scan signal GI, a fourth scan line GBL configured to transmit a fourth scan signal GB, an emission control line EL configured to transmit the emission control signal EM, and the data line DL configured to transmit the data signal DATA. In some aspects, the pixel circuit PC may be electrically connected to a power line PL configured to transmit a driving voltage ELVDD, a first initialization voltage line VIL configured to transmit a first initialization voltage VINT, a second initialization voltage line VL configured to transmit a second initialization voltage VAINT, a reference voltage line VRL configured to transmit a reference voltage VREF, and a bias voltage line VOBSL configured to transmit a bias voltage VOBS. A common voltage ELVSS may be applied to a common electrode of the organic light-emitting diode OLED electrically connected to the pixel circuit PC.

The data line DL may include a first data line DL1 electrically connected to pixels located in the first column, a second data line DL2 electrically connected to pixels located in the second column, and a third data line DL3 electrically connected to pixels located in the third column.

A first transistor T1, which is a driving transistor, may include a gate electrode electrically connected to a first electrode of a holding capacitor Chold, a first region (e.g., a source region) electrically connected to second regions (e.g., drain regions) of an eighth transistor T8, a ninth transistor T9, and a tenth transistor T10, and a second region (e.g., a drain region) outputting current flowing to the organic light-emitting diode OLED in response to an electrical signal applied to the gate electrode.

The gate electrode of the first transistor T1 may be electrically connected to a second region (e.g., a drain region) of a third transistor T3 and a second region (e.g., a drain region) of a fourth transistor T4. The first region of the first transistor T1 may be electrically connected to the power line PL through the eighth transistor T8 or the tenth transistor T10. In an embodiment, the first region of the first transistor T1 may be electrically connected to the power line PL directly. The second region of the first transistor T1 is electrically connected to a first region (e.g., a source region) of the third transistor T3 and a first region (e.g., a source region) of a sixth transistor T6. The current from the first transistor T1 may be transmitted to the organic light-emitting diode OLED via the sixth transistor T6 such that the organic light-emitting diode OLED emits light. In this way, the brightness of light emitted by the organic light-emitting diode OLED may be determined by the amount of current from the first transistor T1.

For reference, when a region of one transistor and a region of another transistor are electrically connected, the region of one transistor and the region of another transistor may be electrically connected to each other by a connection electrode, or the region of one transistor and the region of another transistor may be integrally formed as a single unitary indivisible body. For example, a semiconductor layer of one transistor and a semiconductor layer of another transistor may be integrally formed as a single unitary indivisible body. This applies to the following embodiments and modifications thereof.

A second transistor T2, which is a switching transistor, may include a gate electrode electrically connected to the first scan line GWL transmitting the first scan signal GW, a first region (e.g., a source region) electrically connected to the data line DL transmitting the data signal DATA, and a second region (e.g., a drain region) electrically connected to a second electrode of the holding capacitor Chold. The second transistor T2 may be turned on by the first scan signal GW such that the data signal DATA may be stored in the holding capacitor Chold. The second region of the second transistor T2 may be electrically connected to not only the second electrode of the holding capacitor Chold but also a second region (e.g., a drain region) of a fifth transistor T5 and a first electrode of a storage capacitor Cst. Each of the second region of the second transistor T2, the second region of the fifth transistor T5, the first electrode of the storage capacitor Cst, and the second electrode of the holding capacitor Chold may have a same electric potential and may be regarded as a first node N1.

The holding capacitor Chold may include the first electrode and the second electrode. The first electrode of the holding capacitor Chold may be electrically connected to the gate electrode of the first transistor T1 to form a second node N2. The first electrode of the holding capacitor Chold and the gate electrode of the first transistor T1 may be integrally formed as a single unitary indivisible body as described herein. The second electrode of the holding capacitor Chold may be electrically connected to the second region of the second transistor T2, the second region of the fifth transistor T5, and the first electrode of the storage capacitor Cst. The second electrode of the holding capacitor Chold and the first electrode of the storage capacitor Cst may be integrally formed as a single unitary indivisible body as described herein. The holding capacitor Chold may receive the data signal DATA from the second transistor T2 such that the gate electrode of the first transistor T1 has electric potential of the data signal DATA.

The storage capacitor Cst may include the first electrode electrically connected to the second electrode of the holding capacitor Chold and a second electrode electrically connected to the power line PL. The first electrode of the storage capacitor Cst may be electrically connected to the second region of the second transistor T2 and the second region of the fifth transistor T5 as described herein. The first electrode of the storage capacitor Cst and the second electrode of the holding capacitor Chold may be integrally formed as a single unitary indivisible body. For example, one electrode may be the first electrode of the storage capacitor Cst and at the same time the second electrode of the holding capacitor Chold. The storage capacitor Cst may prevent or minimize the electric potential of the second electrode of the holding capacitor Chold which is the first node N1 from being affected by electric signal from a neighboring component.

The third transistor T3, which is a compensation transistor, may include a gate electrode electrically connected to the second scan line GCL transmitting the second scan signal GC, the first region electrically connected to the second region of the first transistor T1, and the second region electrically connected to the first electrode of the holding capacitor Chold. The third transistor T3 may be turned on in response to the second scan signal GC and electrically connect the gate electrode of the first transistor T1 and the second region of the first transistor T1 to diode-connect the first transistor T1. Through this, the third transistor T3 may form a compensation path which may compensate for the threshold voltage of the first transistor T1, thereby allowing the threshold voltage of the first transistor T1 to be transmitted to the first electrode of the holding capacitor Chold. As a result, even if the threshold voltages of the first transistors T1 included in the pixels PX are different from one another, the first transistors T1 of the pixels PX to which the same data signal DATA is applied may output the same or similar amount of current flowing to the organic light-emitting diodes OLED.

The fourth transistor T4, which may be a first initialization transistor, may include the gate electrode electrically connected to the third scan line GIL transmitting the third scan signal GI, a first region (e.g., a source region) electrically connected to the first initialization voltage line VIL transmitting the first initialization voltage VINT, and the second region (e.g., the drain region) electrically connected to the gate electrode of the first transistor T1. The second region of the fourth transistor T4 may be electrically connected to not only the gate electrode of the first transistor T1 but also the first electrode of the holding capacitor Chold and the second region of the third transistor T3. The fourth transistor T4 may be turned on in response to the third scan signal GI to initialize the first electrode of the holding capacitor Chold and the gate electrode of the first transistor T1, i.e., the second node N2, to the first initialization voltage VINT.

The fifth transistor T5, which may be a reference voltage transistor, may include the gate electrode electrically connected to the second scan line GCL transmitting the second scan signal GC, a first region (e.g., a source region) electrically connected to the reference voltage line VRL transmitting the reference voltage VREF, and the second region (e.g., the drain region) electrically connected to the second electrode of the holding capacitor Chold. The second region of the fifth transistor T5 may be electrically connected to not only the second electrode of the holding capacitor Chold, but also the first electrode of the storage capacitor Cst and the second region of the second transistor T2. The fifth transistor T5 may be turned on by the second scan signal GC to initialize the second electrode of the holding capacitor Chold and the first electrode of the storage capacitor Cst, i.e., the first node N1, to the reference voltage VREF.

The reference voltage line VRL which transmits the reference voltage VREF may include a first reference voltage line VRL1 and a second reference voltage line VRL2 which are electrically connected to each other. For example, the first reference voltage lines VRL1 extend in the first direction (x-axis direction) and the second reference voltage lines VRL2 extend in the second direction (y-axis direction), such that the reference voltage lines VRL in the display area DA may have a mesh structure. This structure will be described herein.

FIG. 8 illustrates that the second scan line GCL transmits the second scan signal GC to the third transistor T3 which is the compensation transistor and the fifth transistor T5 which is the reference voltage transistor, but one or more embodiments are not limited thereto. For example, the second scan line GCL may include a second-1 scan line GCL1 transmitting the second scan signal GC to the fifth transistor T5 and a second-2 scan line GCL2 transmitting the second scan signal GC to the third transistor T3.

The sixth transistor T6, which may be an emission control transistor, may include a gate electrode electrically connected to the emission control line EL transmitting the emission control signal EM, the first region (e.g., the source region) electrically connected to the second region of the first transistor T1, and a second region (e.g., a drain region) electrically connected to a pixel electrode of the organic light-emitting diode OLED. The first region of the sixth transistor T6 may be electrically connected to not only the second region of the first transistor T1 but also the first region of the third transistor T3, and the second region of the sixth transistor T6 may be electrically connected to not only the pixel electrode of the organic light-emitting diode OLED but also a second region (e.g., a drain region) of a seventh transistor T7. The sixth transistor T6 may be turned on in response to the emission control signal EM such that the current from the first transistor T1 flows to the organic light-emitting diode OLED.

The seventh transistor T7, which may be a second initialization transistor, may include a gate electrode electrically connected to the fourth scan line GBL transmitting the fourth scan signal GB, a first region (e.g., a source region) electrically connected to the second initialization voltage line VL transmitting the second initialization voltage VAINT, and the second region (e.g., the drain region) electrically connected to the pixel electrode of the organic light-emitting diode OLED. The second region of the seventh transistor T7 may be electrically connected to not only the pixel electrode of the organic light-emitting diode OLED but also the second region of the sixth transistor T6. The seventh transistor T7 may be turned on in response to the fourth scan signal GB and initialize the electric potential of the pixel electrode of the organic light-emitting diode OLED to the second initialization voltage VAINT.

The second initialization voltage VAINT to be applied to the pixel electrode of the organic light-emitting diode OLED may differ for each pixel. For example, the second initialization voltage VAINT to be applied to the pixel electrode of the organic light-emitting diode OLED of a pixel emitting red light, the second initialization voltage VAINT to be applied to the pixel electrode of the organic light-emitting diode OLED of a pixel emitting green light, and the second initialization voltage VAINT to be applied to the pixel electrode of the organic light-emitting diode OLED of a pixel emitting blue light may be different from one another. Accordingly, the second initialization voltage line VL may include a second-1 initialization voltage line for a first pixel emitting red light, a second-2 initialization voltage line for a second pixel emitting green light, and a second-3 initialization voltage line for a third pixel emitting blue light.

Alternatively, for one pixel among the red light-emitting pixel, the green light-emitting pixel, and the blue light-emitting pixel, the second initialization voltage with a first level may be applied to the pixel electrode of the one pixel, while the second initialization voltage with a second level which is different from the first level may be applied to the pixel electrodes of the other pixels. In this case, pixels to which the second initialization voltage with the same level is applied may share the second initialization voltage line. For example, the second initialization voltage line VL may include a second-1 initialization voltage line VL1 for the first pixel and a second-2 initialization voltage line VL2 for the second and third pixels.

The eighth transistor T8, which is an operation control transistor, is interposed between the first transistor T1, which is the driving transistor, and the power line PL, and is turned on in response to the emission control signal EM from the emission control line EL, such that the driving voltage ELVDD from the power line PL may be applied to the first region of the first transistor T1.

The ninth transistor T9, which is a bias transistor, is turned on in response to the fourth scan signal GB from the fourth scan line GBL to apply bias voltage VOBS from a bias voltage line VOBSL to the first region of the first transistor T1, such that a voltage suitable for the subsequent operation of the first transistor T1 which is the driving transistor may be preset. In this viewpoint, the fourth scan line GBL may be referred to as a bias gate line.

The tenth transistor T10, which is a compensation initialization transistor, is turned on in response to the second scan signal GC from the second scan line GCL, such that the driving voltage ELVDD from the power line PL may be applied to the first region of the first transistor T1. Therefore, the first region of the first transistor T1 may be made to have the electric potential of the driving voltage ELVDD during the compensation period.

For reference, FIG. 8 illustrates that each of the transistors is a PMOS (P-channel MOSFETs), but one or more embodiments are not limited thereto. For example, at least one transistor may be an NMOS (N-channel MOSFET), or each of the transistors may be NMOS. If the at least one transistor is an NMOS, a first region of the transistor may be the drain region and a second region of the transistor may be the source region. For reference, a PMOS thin film transistor may be turned on when an electrical signal applied to a gate electrode of the PMOS thin film transistor is a low level signal (low voltage signal), and may be turned off when the electrical signal applied to the gate electrode of the PMOS thin film transistor is a high level signal (high voltage signal). The NMOS thin film transistor may be turned on when an electrical signal applied to a gate electrode of the NMOS thin film transistor is a high level signal (high voltage signal), and may be turned off when the electrical signal applied to the gate electrode of the NMOS thin film transistor is a low level signal (low voltage signal). Hereinafter, for convenience of descriptions, it is described that each of the transistors is PMOS (P-channel MOSFETs).

The organic light-emitting diode OLED may include the pixel electrode electrically connected to the second region of the sixth transistor T6, the common electrode integrally formed as a single unitary indivisible body throughout the plurality of pixels PX, and an intermediate layer interposed between the pixel electrode and the common electrode and including at least an emission layer. The common voltage ELVSS may be applied to the common electrode. The organic light-emitting diode OLED may emit light with a brightness corresponding to the current determined by the first transistor T1.

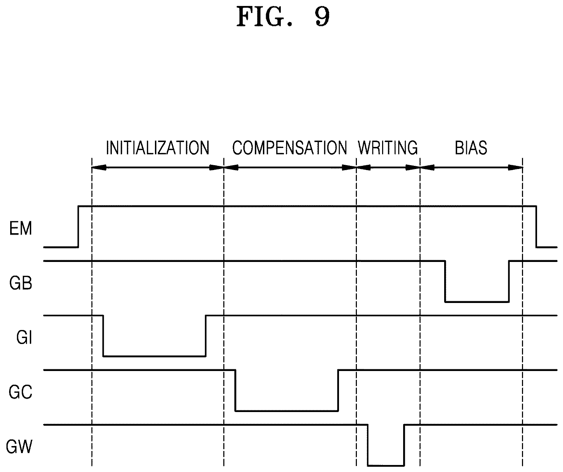

Below, with reference to FIG. 9, which is a waveform diagram illustrating an electrical signal which may be applied to the pixel circuit PC of FIG. 8, the operation of the pixel circuit PC of FIG. 8 is briefly described.

As illustrated in FIG. 9, when a signal applied to a pixel is divided into periods, the periods may be divided into an initialization period, a compensation period, a writing period, and a bias period. For reference, although not illustrated in FIG. 9, a period in which the emission control signal EM has a low level signal may be referred to as an emission period.

When the emission control signal EM becomes a high level signal, the emission period may end. A period where the emission control signal EM is the high level signal may include the initialization period, the compensation period, the writing period, and the bias period.

The initialization period may be a period where the third scan signal GI is approximately a low level signal. In the initialization period, the fourth transistor T4 to which the third scan signal GI is applied is turned on such that a voltage (electric potential) of the first electrode of the holding capacitor Chold, the gate electrode of the first transistor T1, and the second region of the third transistor T3, which are electrically connected to the second region of the fourth transistor T4, is initialized to the first initialization voltage VINT. The first initialization voltage VINT may be a low level signal which may turn on the first transistor T1. As a result, the first transistor T1 may be turned on in the initialization period.

When the initialization period ends, the compensation period may be entered. In an example in which the third scan signal GI is changed to a high level signal, the initialization period ends, and the compensation period is entered, in which the second scan signal GC is approximately a low level signal. In the compensation period, the third transistor T3, the fifth transistor T5, and the tenth transistor T10 which receive the second scan signal GC may be turned on.

When the fifth transistor T5 is turned on, the electric potential of the second electrode of the holding capacitor Chold, the first electrode of the storage capacitor Cst, and the second region of the second transistor T2, which are electrically connected to the second region of the fifth transistor T5, may be initialized to the reference voltage VREF. In other words, the first node N1 may be initialized to the reference voltage VREF. In an example in which the tenth transistor T10 is turned on, the voltage of the first region of the first transistor T1 may become the driving voltage ELVDD transmitted by the power line PL. The third transistor T3 is also turned on to electrically connect the second region of the first transistor T1 and the gate electrode of the first transistor T1 to each other. As a result, in the compensation period, the electric potential of the gate electrode of the first transistor T1, i.e., the electric potential of the second node N2, gradually increases from the first initialization voltage VINT, and when the electric potential of the second node N2 corresponds to a threshold voltage Vth (Vth is a (-) value) of the first transistor T1, the first transistor T1 is turned off. Therefore, the electric potential of the gate electrode of the first transistor T1 may become the threshold voltage Vth of the first transistor T1. After the compensation period, the second electrode of the holding capacitor Chold may have the reference voltage VREF, and the first electrode of the holding capacitor Chold may have the threshold voltage Vth of the first transistor T1.

When the compensation period ends, the writing period is entered. In an embodiment, when the second scan signal GC changes to a high level signal, the compensation period ends, and the writing period in which the first scan signal GW is approximately a low level signal begins. In the writing period, the second transistor T2 to which the first scan signal GW is applied is turned on.

When the second transistor T2 is turned on, the data signal DATA is transmitted to the first node N1 which is the second region of the second transistor T2, through the second transistor T2, such that the electric potential of the second region of the second transistor T2, the second electrode of the holding capacitor Chold, the first electrode of the storage capacitor Cst, and the second region of the fifth transistor T5, each of which is the first node N1, may be changed into the data signal DATA. The electric potential of the second electrode of the storage capacitor Cst, which is maintained as the reference voltage VREF in the compensation period, is changed to the data signal VDATA in the writing period. In this case, the electric potential of the first electrode of the holding capacitor Chold is changed in proportion to an amount of change of the electric potential of the second electrode of the holding capacitor Chold. Because the change of the electric potential of the second electrode of the holding capacitor Chold is the difference between the data signal DATA and the reference voltage VREF, the electric potential of the first electrode of the holding capacitor Chold changes by a value which is proportional to this difference from the threshold voltage Vth. Accordingly, the electric potential of the first electrode of the holding capacitor Chold is lowered, and a degree to which the first transistor T1 is turned on during the emission period is determined by the lowered voltage of the gate electrode of the first transistor T1 which is the driving transistor, such that the amount of the output current from the first transistor T1 may be determined.

When the writing period ends, the bias period is entered. In an embodiment, when the first scan signal GW changes to a high level signal, the write period ends and the bias period in which the fourth scan signal GB is approximately a low level signal is entered. In the bias period, the seventh transistor T7 and the ninth transistor T9 to which the fourth scan signal GB is applied are turned on.

When the seventh transistor T7 is turned on, the electric potential of the pixel electrode of the organic light-emitting diode OLED and the second region of the sixth transistor T6 which are electrically connected to the second region of the seventh transistor T7 is initialized to the second initialization voltage VAINT. Because the electric potential of the pixel electrode of the organic light-emitting diode OLED is initialized in this way, the bias period may also be referred to as a pixel electrode initialization period. In an example in which the ninth transistor T9 is turned on, the bias voltage VOBS from the bias voltage line VOBSL is transmitted to the first region of the first transistor T1 through the ninth transistor T9, such that a voltage of the first region of the first transistor T1 may be preset to a voltage suitable for the subsequent operation of the first transistor T1, which is the driving transistor.

When the bias period ends, the emission period is entered. In an embodiment, when the fourth scan signal GB changes to a high level signal, the bias period ends and the emission period in which the emission control signal EM is approximately a low level signal is entered. In the emission period, the sixth transistor T6 and the eighth transistor T8 to which the emission control signal EM is applied are turned on.

When the eighth transistor T8 is turned on, the driving voltage ELVDD from the power line PL is transmitted to the first region of the first transistor T1 through the eighth transistor T8. In an example in which the sixth transistor T6 is turned on, the output current from the second region of the first transistor T1, which is determined according to the electric potential of the gate electrode of the first transistor T1, is transmitted to the organic light-emitting diode OLED through the turned-on sixth transistor T6, such that the organic light-emitting diode OLED may emit light. FIG. 9 illustrates a portion of the emission period for convenience, however, the emission period is the longest among the various periods. When the emission period ends, the initialization period described herein may be entered.

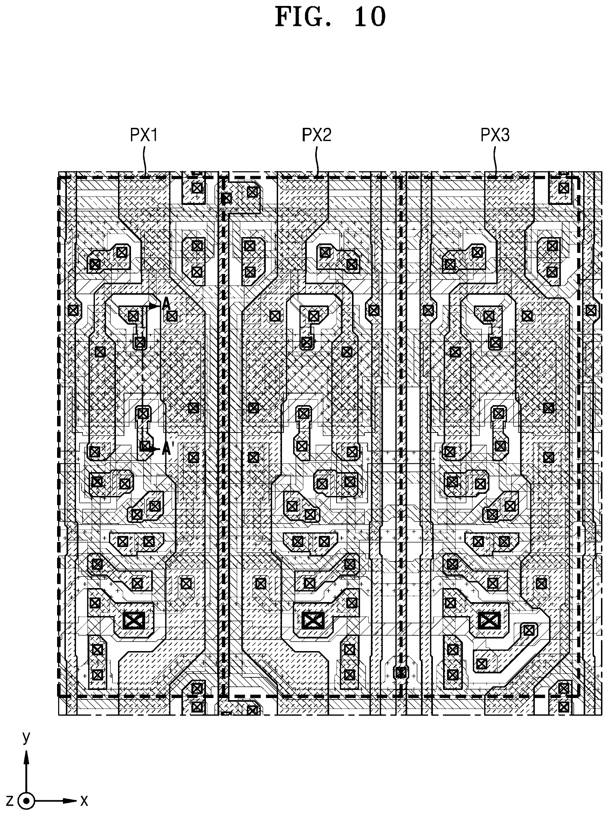

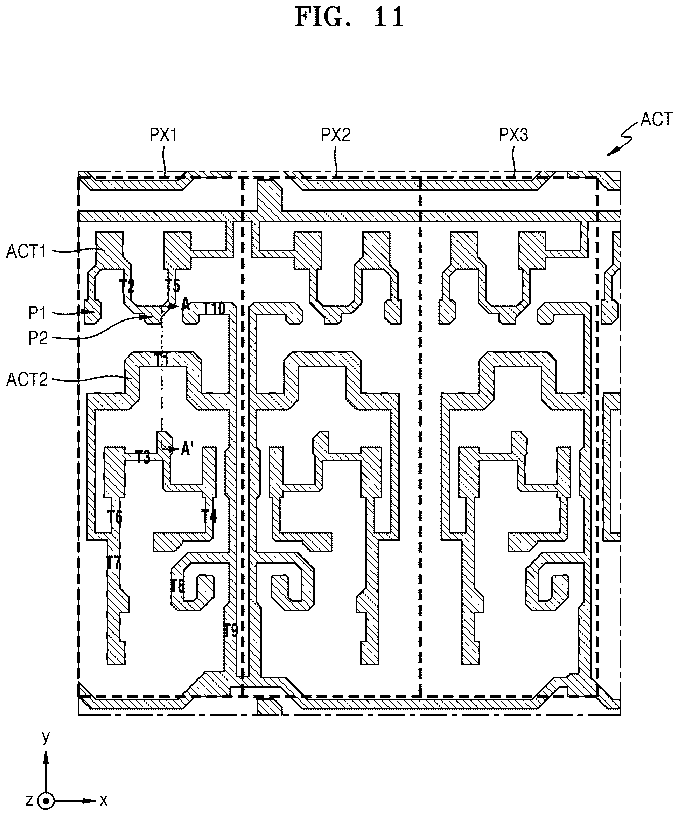

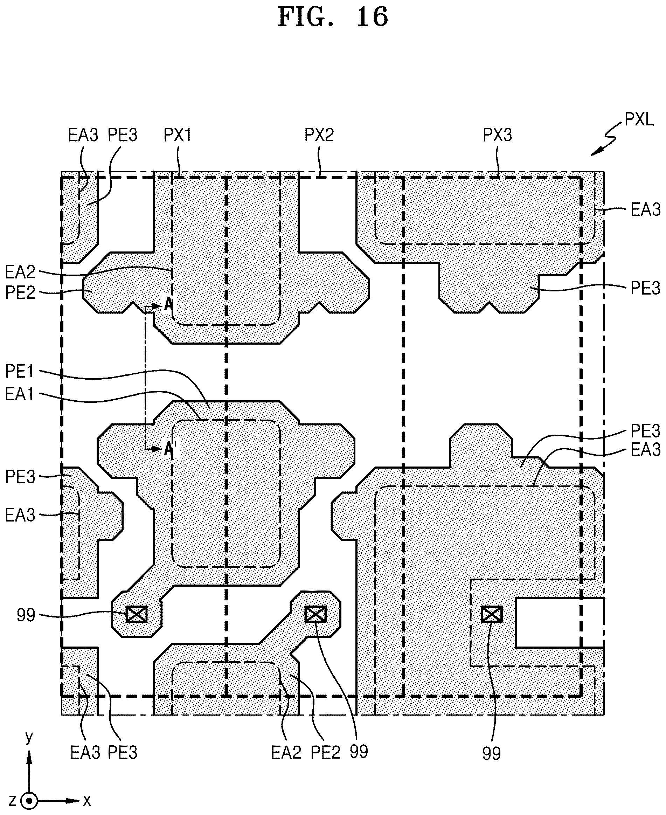

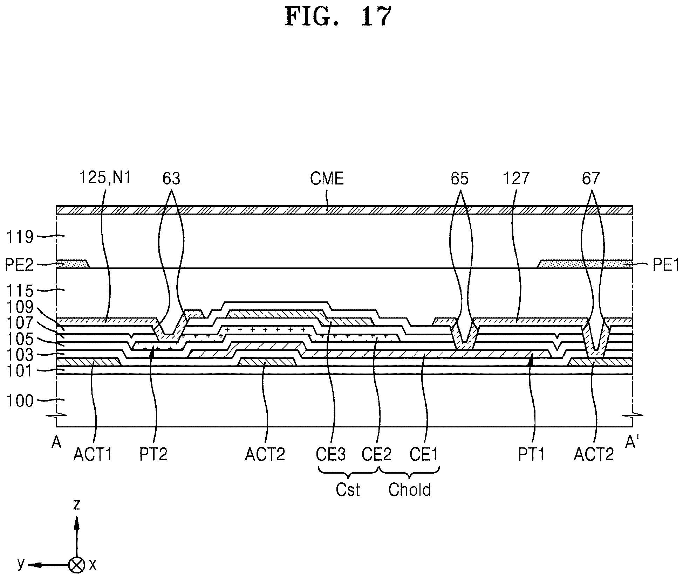

FIG. 10 is a layout diagram schematically illustrating the locations of the plurality of transistors T1, T2, T3, T4, T5, T6, T7, T8, T9, and T10, the plurality of capacitors Cst and Chold, and other components in pixels PX included in the display panel 10 of the display module 11 of FIG. 7. FIGS. 11 to 15 are layout diagrams schematically illustrating, layer by layer, components illustrated in FIG. 10. For example, FIGS. 11 to 15 are layout diagrams schematically illustrating, layer by layer, the plurality of transistors T1, T2, T3, T4, T5, T6, T7, T8, T9, and T10, the plurality of capacitors Cst and Chold, and other components illustrated in FIG. 10. FIG. 16 is a layout diagram illustrating pixel electrodes PE1, PE2, and PE3 which may be electrically connected to the pixel circuits of FIG. 10. FIG. 17 is a cross-sectional view schematically illustrating a cross-section of the display module 11 taken along line A-A' of FIG. 10. Sizes of components in the cross-sectional view may be exaggerated or reduced for convenience of descriptions.

As illustrated in FIGS. 10 to 15, the display panel 10 and the electronic apparatus 1 having the display panel 10 may have a structure in which sets, each of which includes a first pixel PX1, a second pixel PX2, and a third pixels PX3 sequentially arranged in the first direction (x-axis direction), are repeatedly arranged in the first direction (x-axis direction). These sets may also be repeatedly arranged in the second direction (y-axis direction).

For reference, regions where the first pixel PX1, the second pixel PX2, and the third pixel PX3 are located in FIGS. 10 to 15 may denote regions where the pixel circuit included in the first pixel PX1, the pixel circuit included in the second pixel PX2, and the pixel circuit included in the third pixel PX3 are located. A display element included in the first pixel PX1 does not necessarily have to be located within the region indicated by the first pixel PX1. In one or more embodiments, as illustrated in FIG. 16, a first pixel electrode PE1 electrically connected to the pixel circuit included in the first pixel PX1 may be located across the region indicated as the first pixel PX1 and the region indicated as the second pixel PX2. A second pixel electrode PE2 electrically connected to the pixel circuit included in the second pixel PX2 may be located in the -y direction from the first pixel electrode PE1 and may be located across the region indicated as the first pixel PX1 and the region indicated as the second pixel PX2. A third pixel electrode PE3 electrically connected to the pixel circuit included in the third pixel PX3 may be located across the region indicated as the second pixel PX2 and the region indicated as the third pixel PX3, and may also be located across the regions indicated as the second and third pixels PX2 and PX3 and the regions of pixels located in the -y direction from the second and third pixels PX2 and PX3. In this case, the first pixel electrodes PE1 and the second pixel electrodes PE2 may be alternately located in one column, and the third pixel electrodes PE3 may be located in another column, and these two columns may be arranged alternately along the first direction (x-axis direction).

The pixel circuit of the first pixel PX1 may be a first-color pixel circuit, the pixel circuit of the second pixel PX2 may be a second-color pixel circuit, and the pixel circuit of the third pixel PX3 may be a third-color pixel circuit. For example, the first-color may be red, the second-color may be green, and the third-color may be blue.

The first pixel PX1 and the second pixel PX2 neighboring each other may be approximately mirror-symmetrical with respect to a boundary between the first pixel PX1 and the second pixel PX2. In the case of the second pixel PX2 and the third pixel PX3, they may be approximately mirror-symmetrical with respect to a boundary between the second pixel PX2 and the third pixel PX3.

Hereinbelow, for convenience of descriptions, some components are described based on the pixel circuit of the first pixel PX1, but these components may also be located symmetrically or identically in the second pixel PX2 and/or in the third pixel PX3.

A buffer layer 101 (see FIG. 17) including an inorganic insulating material such as, for example, silicon oxide, silicon nitride and/or silicon oxynitride may be disposed over the substrate 100. The buffer layer 101 may prevent metal atoms or impurities from diffusing from the substrate 100 to a semiconductor layer ACT disposed thereon. In some aspects, the buffer layer 101 may support uniform crystallization of the semiconductor layer ACT by adjusting a transfer rate of heat during a crystallization process for forming the semiconductor layer ACT.

The semiconductor layer ACT illustrated in FIG. 11 may be disposed on the buffer layer 101. The semiconductor layer ACT may include a silicon semiconductor. As an example, the semiconductor layer ACT may include amorphous silicon or polycrystalline silicon. In the latter case, the semiconductor layer ACT may include polycrystalline silicon crystallized at low temperature. In one or more embodiments, ions may be implanted in at least a portion of the semiconductor layer ACT. In one or more embodiments, a lower metal layer approximately corresponding to the shape of the semiconductor layer ACT may be disposed under the semiconductor layer ACT to protect the semiconductor layer ACT. In this case, an insulating layer may be disposed between the lower metal layer and the semiconductor layer ACT.

The semiconductor layer ACT in the first pixel PX1 may include a first semiconductor layer ACT1 and a second semiconductor layer ACT2 spaced apart from each other. One or more embodiments are not limited thereto. For example, the first semiconductor layer ACT1 and the second semiconductor layer ACT2 may be integrally formed as a single unitary indivisible body.

The first semiconductor layer ACT1 of the first pixel PX1 and the first semiconductor layer ACT1 of the second pixel PX2 adjacent to the first pixel PX1 in the +x direction may be integrally formed as a single unitary indivisible body. FIG. 11 illustrates that the first semiconductor layer ACT1 of the first pixel PX1, the first semiconductor layer ACT1 of the second pixel PX2, and the first semiconductor layer ACT1 of the third pixel PX3 adjacent to the second pixel PX2 in the +x direction, are integrally formed as a single unitary indivisible body. In an embodiment, the first semiconductor layers ACT1 of the pixels may be spaced apart from one another. The second semiconductor layer ACT2 of the first pixel PX1, the second semiconductor layer ACT2 of the second pixel PX2, and the second semiconductor layer ACT2 of the third pixel PX3 may be integrally formed as a single unitary indivisible body. In an embodiment, the second semiconductor layers ACT2 of the pixels may be spaced apart from one another.

Each of the first semiconductor layer ACT1 and the second semiconductor layer ACT2 may have a shape curved in various shapes. The first transistor T1, the second transistor T2, the third transistor T3, the fourth transistor T4, the fifth transistor T5, the sixth transistor T6, the seventh transistor T7, the eighth transistor T8, the ninth transistor T9, and the tenth transistor T10 may be located along the first semiconductor layer ACT1 and the second semiconductor layer ACT2.

In an embodiment, the second transistor T2 which is the switching transistor and the fifth transistor T5 which is the reference voltage transistor may be located along the first semiconductor layer ACT1, the first transistor T1 which is the driving transistor, the third transistor T3 which is the compensation transistor, the fourth transistor T4 which is the first initialization transistor, the sixth transistor T6 which is the emission control transistor, the seventh transistor T7 which is the second initialization transistor, the eighth transistor T8 which is the operation control transistor, the ninth transistor T9 which is the bias transistor, and the tenth transistor T10 which is the compensation initialization transistor may be located along the second semiconductor layer ACT2. The first semiconductor layer ACT1 may include a channel region of each of the second transistor T2 and the fifth transistor T5, a source region on one side of the channel region, and a drain region on the other side of the channel region. Similarly, the second semiconductor layer ACT2 may include a channel region of each of the first transistor T1, the third transistor T3, the fourth transistor T4, the sixth transistor T6, the seventh transistor T7, the eighth transistor T8, the ninth transistor T9, and the tenth transistor T10, a source region on one side of the channel region, and a drain region on the other side of the channel region. In FIG. 11, the positions of the channel regions of the transistors T1, T2, T3, T4, T5, T6, T7, T8, T9, and T10 are denoted by reference symbols of the transistors T1, T2, T3, T4, T5, T6, T7, T8, T9, and T10. A source region and a drain region are located on one side and the other side of a channel region.

A first gate insulating layer 103 (see FIG. 17) may cover the semiconductor layer ACT and be disposed on the substrate 100 (or the buffer layer 101). The first gate insulating layer 103 may include an insulating material. As an example, the first gate insulating layer 103 may include silicon oxide, silicon nitride, silicon oxynitride, or aluminum oxide.

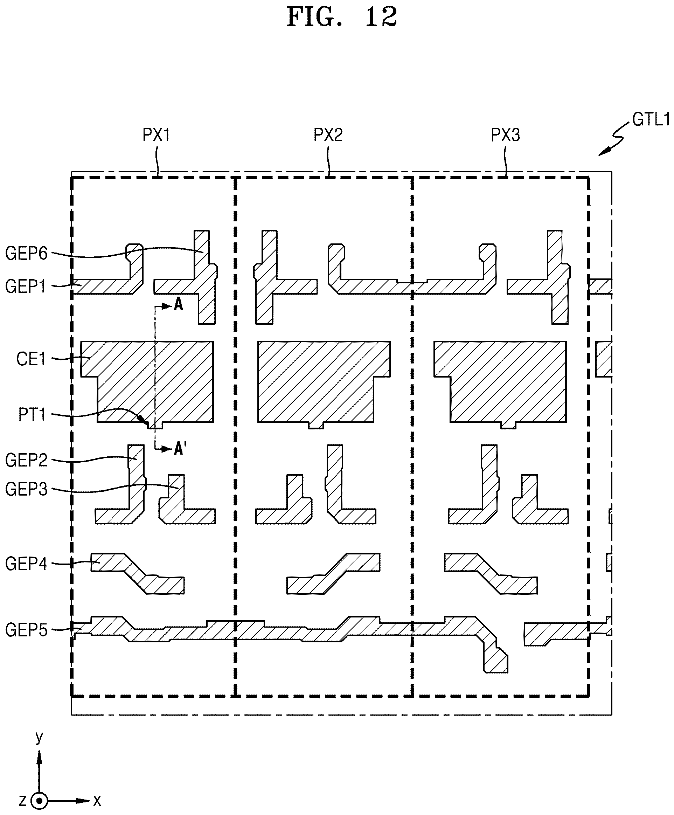

A first gate layer GTL1 illustrated in FIG. 12 may be disposed on the first gate insulating layer 103. The first gate layer GTL1 may include a first capacitor electrode CE1 which is the first electrode of the holding capacitor Chold and has an isolated shape, a first gate electrode portion GEP1, a second gate electrode portion GEP2, a third gate electrode portion GEP3, a fourth gate electrode portion GEP4, a fifth gate electrode portion GEP5, and a sixth gate electrode portion GEP6. The first capacitor electrode CE1 may also function as a driving gate electrode of the first transistor T1 which is the driving transistor.

Portions of the first capacitor electrode CE1, the first gate electrode portion GEP1, the second gate electrode portion GEP2, the third gate electrode portion GEP3, the fourth gate electrode portion GEP4, the fifth gate electrode portion GEP5, and the sixth gate electrode portion GEP6 which overlap the semiconductor layer ACT may function as gate electrodes of the transistors.

For example, a portion of the first gate electrode portion GEP1 overlapping the first semiconductor layer ACT1 may be the gate electrode of the second transistor T2 which is the switching transistor, a portion of the second gate electrode portion GEP2 overlapping the second semiconductor layer ACT2 may be the gate electrode of the third transistor T3 which is the compensation transistor, a portion of the third gate electrode portion GEP3 overlapping the second semiconductor layer ACT2 may be the gate electrode of the fourth transistor T4 which is the first initialization transistor, portions of the fourth gate electrode portion GEP4 overlapping the second semiconductor layer ACT2 may be the gate electrode of the sixth transistor T6 which is the emission control transistor and the gate electrode of the eighth transistor T8 which is the operation control transistor, portions of the fifth gate electrode portion GEP5 overlapping the second semiconductor layer ACT2 may be the gate electrode of the seventh transistor T7 which is the second initialization transistor and the gate electrode of the ninth transistor T9 which is the bias transistor, a portion of the sixth gate electrode portion GEP6 overlapping the first semiconductor layer ACT1 may be the gate electrode of the fifth transistor T5 which is the reference voltage transistor, and a portion of the sixth gate electrode portion GEP6 overlapping the second semiconductor layer ACT2 may be the gate electrode of the tenth transistor T10 which is the compensation initialization transistor.

In one or more embodiments, the first semiconductor layer ACT1 may have a bent shape and the first gate electrode portion GEP1 may have a bent shape, such that first gate electrode portion GEP1 may overlap the first semiconductor layer ACT1 twice. In this case, the second transistor T2 which is the switching transistor may be a dual gate transistor having two gate electrodes and two channel regions. In one or more embodiments, the second semiconductor layer ACT2 may also have a bent shape and the second gate electrode portion GEP2 may also have a bent shape, such that second gate electrode portion GEP2 may overlap the second semiconductor layer ACT2 twice. Therefore, the third transistor T3 which is the compensation transistor may be a dual gate transistor having two gate electrodes and two channel regions. Similarly, because the third gate electrode portion GEP3 overlaps the second semiconductor layer ACT2 twice and the sixth gate electrode portion GEP6 overlaps the first semiconductor layer ACT1 twice, each of the fourth transistor T4 which is the first initialization transistor and the fifth transistor T5 which is the reference voltage transistor may be dual gate transistors having two gate electrodes and two channel regions.

The first gate layer GTL1 may include metal, an alloy, a conductive metal oxide, or a transparent conductive material and the like. As an example, the first gate layer GTL1 may include silver (Ag), an alloy containing silver, molybdenum (Mo), an alloy containing molybdenum, aluminum (Al), an alloy containing aluminum, aluminum nitride (AIN), tungsten (W ), tungsten nitride (WN), copper (Cu), nickel (Ni), chrome (Cr), chrome nitride (CrN), titanium (Ti), tantalum (Ta), platinum (Pt), scandium (Sc), indium tin oxide (ITO) or indium zinc oxide (IZO), and the like. The first gate layer GTL1 may have a multi-layered structure. For example, the first gate layer GTL1 may have a two-layered structure of Mo/Al or a three-layered structure of Mo/Al/Mo.

A second gate insulating layer 105 (see FIG. 17) may cover the first gate layer GTL1 and be disposed on the first gate insulating layer 103. The second gate insulating layer 105 may include an insulating material equal/similar to an insulating material of the first gate insulating layer 103.

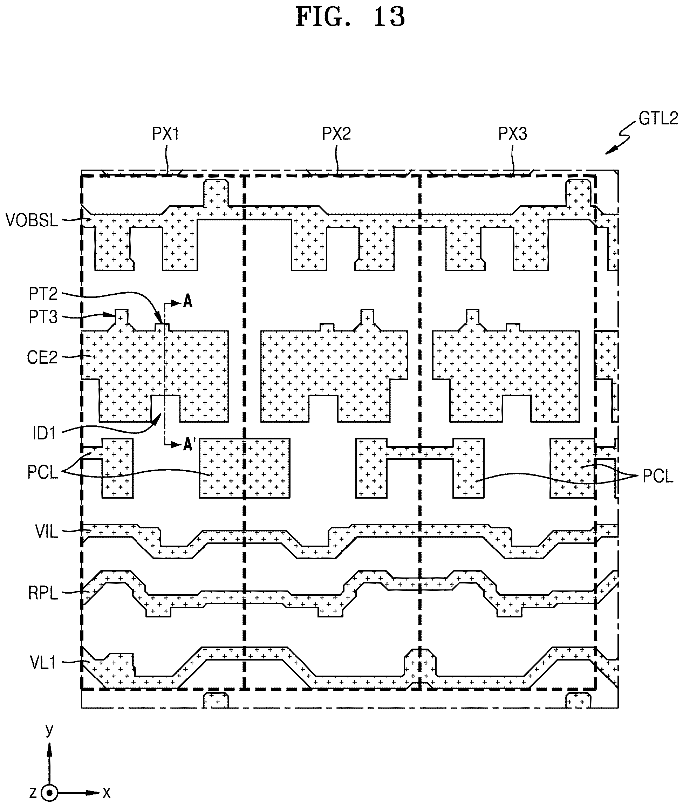

A second gate layer GTL2 illustrated in FIG. 13 may be disposed on the second gate insulating layer 105. The second gate layer GTL2 may include the first initialization voltage line VIL, a repair line RPL, the second-1 initialization voltage line VL1 which is a part of the second initialization voltage line VL, the bias voltage line VOBSL, a second capacitor electrode CE2, and a power connection line PCL.

Each of the first initialization voltage line VIL, the repair line RPL, the second-1 initialization voltage line VL1, and the bias voltage line VOBSL may extend approximately in the first direction (x-axis direction) and may be integrally formed as a single unitary indivisible body throughout a plurality of pixels. The first initialization voltage line VIL may transmit the first initialization voltage VINT to the gate electrode of the first transistor T1, which is the driving transistor, through the fourth transistor T4 which is the first initialization transistor. The second-1 initialization voltage line VL1 may transmit the second initialization voltage VAINT to the first pixel electrode PE1 (see FIG. 16) of the first pixel PX1 through the seventh transistor T7 in the first pixel PX1. The bias voltage line VOBSL may transmit the bias voltage VOBS to the first region of the first transistor T1 through the ninth transistor T9 which is the bias transistor. The repair line RPL is a spare line which may electrically connect a pixel electrode to an adjacent normal pixel circuit, and not to a pixel circuit which is defective.

The second capacitor electrode CE2 may have an isolated shape. The second capacitor electrode CE2 may overlap the first capacitor electrode CE1 when viewed in a direction perpendicular to the substrate 100 (i.e., in a plan view, the same applies hereinafter). The first capacitor electrode CE1 and the second capacitor electrode CE2 may form the holding capacitor Chold. In this way, the second capacitor electrode CE2 may be the second electrode of the holding capacitor Chold. At the same time, the second capacitor electrode CE2 may also function as the first electrode of the storage capacitor Cst.

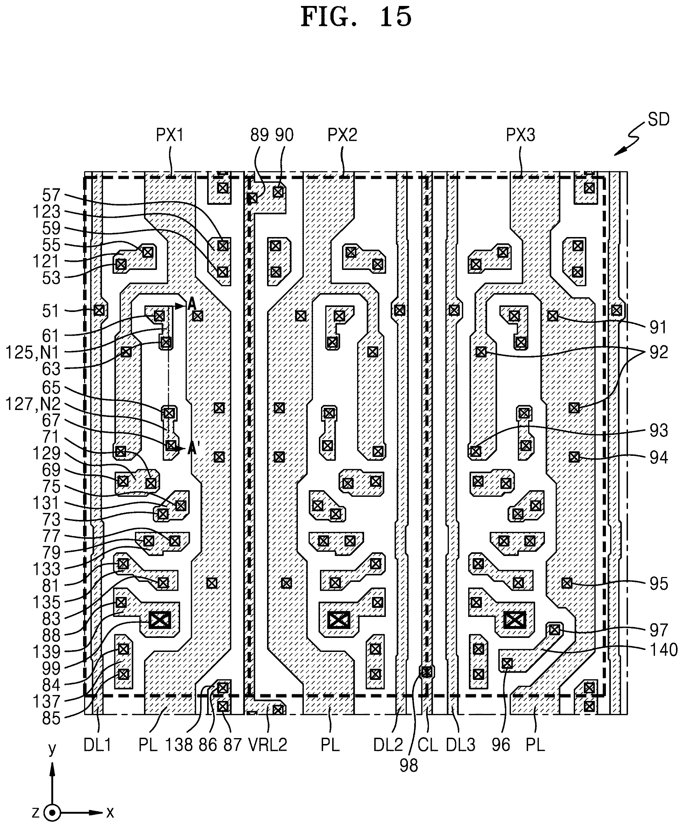

Each of the power connection lines PCL may have an isolated shape. As described herein, each of the power line PL (see FIG. 15) may extend approximately in the second direction (y-axis direction). The power lines PL may be arranged in the first direction (x-axis direction). The power connection lines PCL may electrically connect such power lines PL to each other such that a set of the power lines PL and the power connection lines PCL may have an approximate mesh shape in the display area DA. Therefore, embodiments of the present disclosure may prevent or minimize voltage drops, i.e., IR drop, in the power lines PL.

The second gate layer GTL2 may include metal, an alloy, a conductive metal oxide, or a transparent conductive material and the like. As an example, the second gate layer GTL2 may include silver (Ag), an alloy containing silver, molybdenum (Mo), an alloy containing molybdenum, aluminum (Al), an alloy containing aluminum, aluminum nitride (AIN), tungsten (W ), tungsten nitride (WN), copper (Cu), nickel (Ni), chrome (Cr), chrome nitride (CrN), titanium (Ti), tantalum (Ta), platinum (Pt), scandium (Sc), indium tin oxide (ITO) or indium zinc oxide (IZO), and the like. The second gate layer GTL2 may have a multi-layered structure. For example, the second gate layer GTL2 may have a two-layered structure of Mo/Al or a three-layered structure of Mo/Al/Mo.

A third gate insulating layer 107 (FIG. 17) may cover the second gate layer GTL2 and may be disposed on the second gate insulating layer 105. The third gate insulating layer 107 may include an insulating material equal or similar to an insulating material of the second gate insulating layer 105.

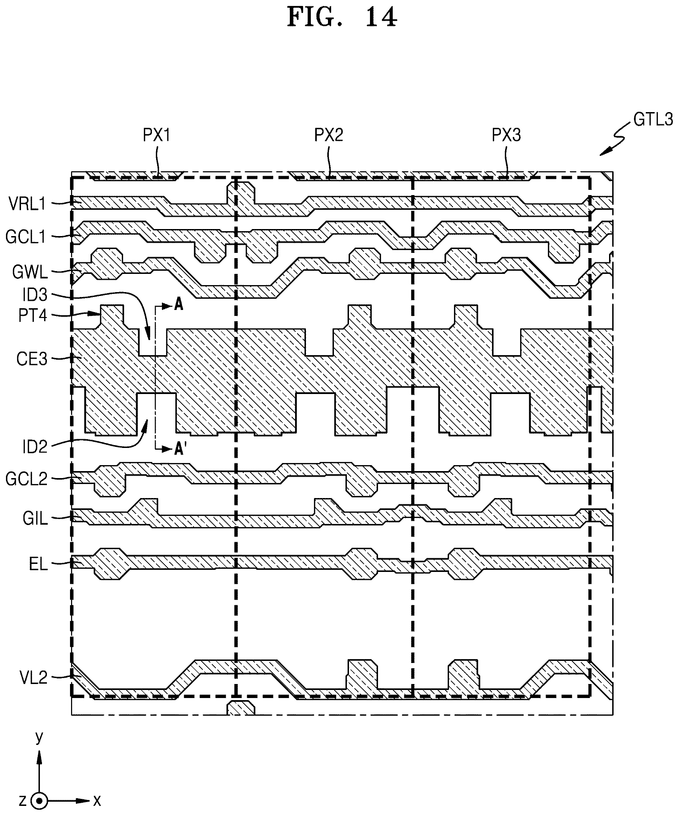

A third gate layer GTL3 illustrated in FIG. 14 may be disposed on the third gate insulating layer 107. The third gate layer GTL3 may include the first reference voltage line VRL1 which is a part of the reference voltage line VRL, the second-1 scan line GCL1 which is a part of the second scan line GCL, the first scan line GWL, the second-2 scan line GCL2 which is a part of the second scan line GCL, the second-2 initialization voltage line VL2 which is a part of the second initialization voltage line VL, the third scan line GIL, the emission control line EL, and a third capacitor electrode CE3.

Each of the first reference voltage line VRL1, the second-1 scan line GCL1, the first scan line GWL, the second-2 scan line GCL2, the second-2 initialization voltage line VL2, the third scan line GIL, and the emission control line EL may extend approximately in the first direction (x-axis direction) and may be integrally formed as a single unitary indivisible body throughout a plurality of pixels. The third capacitor electrodes CE3 arranged along the first direction x-axis direction may be also connected to each other and thus may be formed as a single unitary indivisible body throughout a plurality of pixels. For reference, each of the first capacitor electrode CE1 and the second capacitor electrode CE2 described herein may have an isolated shape within a corresponding pixel, and the third capacitor electrode CE3 described herein may have a shape extending in the first direction (e.g., x-axis direction).

The first reference voltage line VRL1 may be electrically connected to the second reference voltage line VRL2 (see FIG. 15) disposed above the first reference voltage line VRL1 and extending in the second direction (y-axis direction). Accordingly, a set of the first reference voltage lines VRL1 and the second reference voltage lines VRL2 may have a mesh shape in the display area DA, such that embodiments of the present disclosure may prevent or minimize voltage drops, i.e., IR drop, in the reference voltage line VRL. The reference voltage line VRL may transmit the reference voltage VREF to the fifth transistor T5, which is the reference voltage transistor.

The second-1 scan line GCL1 may be electrically connected to the sixth gate electrode portion GEP6 by a connection electrode 123 (see FIG. 15) and may transmit the second scan signal GC to the fifth transistor T5 which is the reference voltage transistor. The first scan line GWL may be electrically connected to the first gate electrode portion GEP1 by a connection electrode 121 (see FIG. 15) and may transmit the first scan signal GW to the second transistor T2 which is the switching transistor. The second-2 scan line GCL2 may be electrically connected to the second gate electrode portion GEP2 by a connection electrode 129 (see FIG. 15) and may transmit the second scan signal GC to the third transistor T3 which is the compensation transistor. The second-2 initialization voltage line VL2 may transmit the second initialization voltage VAINT to the second pixel electrode PE2 (see FIG. 16) of the second pixel PX2 and the third pixel electrode PE3 (see FIG. 16) of the third pixel PX3 through the seventh transistors T7 located in the second pixel PX2 and the third pixel PX3. The third scan line GIL may be electrically connected to the third gate electrode portion GEP3 by a connection electrode 131 (see FIG. 15) and may transmit the third scan signal GI to the fourth transistor T4 which is the first initialization transistor. The emission control line EL may be electrically connected to the fourth gate electrode portion GEP4 by a connection electrode 135 (see FIG. 15) and may transmit the emission control signal EM to the sixth transistor T6 which is the emission control transistor and the eighth transistor T8 which is the operation control transistor. The third capacitor electrode CE3 may overlap the second capacitor electrode CE2 in the plan view. The second capacitor electrode CE2 and the third capacitor electrode CE3 may form the storage capacitor Cst. In this way, the third capacitor electrode CE3 may function as the second electrode of the storage capacitor Cst.

The third gate layer GTL3 may include metal, an alloy, a conductive metal oxide, or a transparent conductive material and the like. As an example, the third gate layer GTL3 may include silver (Ag), an alloy containing silver, molybdenum (Mo), an alloy containing molybdenum, aluminum (Al), an alloy containing aluminum, aluminum nitride (AIN), tungsten (W ), tungsten nitride (WN), copper (Cu), nickel (Ni), chrome (Cr), chrome nitride (CrN), titanium (Ti), tantalum (Ta), platinum (Pt), scandium (Sc), indium tin oxide (ITO) or indium zinc oxide (IZO), and the like. The third gate layer GTL3 may have a multi-layered structure. For example, the third gate layer GTL3 may have a two-layered structure of Mo/Al or a three-layered structure of Mo/Al/Mo.

A first interlayer insulating layer 109 (see FIG. 17) may cover the third gate layer GTL3 and be disposed on the third gate insulating layer 107. The interlayer insulating layer 109 may include an insulating material. For example, the interlayer insulating layer 109 may include silicon oxide, silicon nitride, silicon oxynitride, or aluminum oxide.

A first source-drain layer SD illustrated in FIG. 15 may be disposed on the interlayer insulating layer 109. The source-drain layer SD may include the data line DL, a common line CL, the power line PL, the second reference voltage line VRL2, and connection electrodes 121, 123, 125, 127, 129, 131, 133, 135, 137, 138, 139, and 140. The data line DL may include the first data line DL1, the second data line DL2, and the third data line DL3 as described herein. Each of the first data line DL1, the second data line DL2, the third data line DL3, the common line CL, the power line PL, and the second reference voltage line VRL2 may extend approximately in the second direction (y-axis direction) and may be integrally formed as a single unitary indivisible body throughout a plurality of pixels. Each of the first pixel PX1, the second pixel PX2, and the third pixel PX3 may include connection electrodes 121, 123, 125, 127, 129, 131, 133, 135, 137, and 139, and the first pixel PX1 and the third pixel PX3 may further include a connection electrode 138, and the third pixel PX3 may further include a connection electrode 140. Each of the connection electrodes may have an isolated shape in the plan view.

The first data line DL1 may be connected to the first semiconductor layer ACT1 through a contact hole 51 defined in insulating layers below the third data line DL3 and may transmit the data signal DATA to the first region of the second transistor T2 which is the switching transistor of the first pixel PX1. Similarly, the second data line DL2 may transmit the data signal DATA to the first region of the second transistor T2 of the second pixel PX2, and the third data line DL3 may transmit the data signal DATA to the first region of the second transistor T2 of the third pixel PX3.

The connection electrode 121 may be connected to the first scan line GWL through a contact hole 53 defined in the insulating layer below the connection electrode 121, and may be connected to the first gate electrode portion GEP1 through a contact hole 55 defined in the insulating layers below the connection electrode 121. The connection electrode 123 may be connected to the second-1 scan line GCL1 through a contact hole 57 defined in the insulating layer below the connection electrode 123, and may be connected to the sixth gate electrode portion GEP6 through a contact hole 59 defined in the insulating layers below the connection electrode 123.

The connection electrode 125 may be connected to the first semiconductor layer ACT1 through a contact hole 61 defined in the insulating layers below the connection electrode 125, and may be connected to the second capacitor electrode CE2 through a contact hole 63 defined in the insulating layers below the connection electrode 125, such that the second region of the second transistor T2 which is the switching transistor may be electrically connected to the second electrode of the holding capacitor Chold. In this way, the connection electrode 125 may be the first node N1.

The connection electrode 127 may be connected to the second semiconductor layer ACT2 through a contact hole 67 defined in the insulating layers below the connection electrode 127, and may be connected to the first capacitor electrode CE1 through a contact hole 65 defined in the insulating layers below the connection electrode 127, such that the second region of the third transistor T3 which is the compensation transistor may be electrically connected to the first electrode of the holding capacitor Chold, i.e., to the gate electrode of the first transistor T1 which is the driving transistor. When viewed in the direction perpendicular to the substrate 100 (z-axis direction), the second capacitor electrode CE2 disposed over the first capacitor electrode CE1 overlaps the first capacitor electrode CE1, and a first indented portion ID1 of the second capacitor electrode CE2 is indented (or recessed) inward at a side of the second capacitor electrode CE2 and exposes a portion of the first capacitor electrode CE1, as illustrated in FIG. 13. Accordingly, the connection electrode 127 may be connected to the first capacitor electrode CE1 through the contact hole 65 located in the first indented portion ID1.

For reference, alternatively, the second capacitor electrode CE2 may have a through hole in the second capacitor electrode CE2, and the connection electrode 127 may be connected to the first capacitor electrode CE1 through a contact hole located within the through hole of the second capacitor electrode CE2. However, in this case, since the through hole exists within the second capacitor electrode CE2, the area of the second capacitor electrode CE2 is significantly decreased. If the area of the second capacitor electrode CE2 decreases, the capacitance of the holding capacitor Chold formed by the first capacitor electrode CE1 and the second capacitor electrode CE2 decreases, or the capacitance of the storage capacitor Cst formed by the second capacitor electrode CE2 and the third capacitor electrode CE3 decreases. Especially in the case of high-resolution display apparatuses, the decrease of the area of the second capacitor electrode CE2 due to the through hole may become more significant. For example, if the capacitance of a capacitor decreases, the electric potential of the capacitor may be affected by an electrical signal from an adjacent data line DL, and thus the display panel and the electronic apparatus including the display panel may display degraded images.

However, in the case of the display panel 10 according to the embodiment described herein and the electronic apparatus 1 including the display panel 10, the second capacitor electrode CE2 does not have the through hole but has the first indented portion ID1 at a side of the second capacitor electrode CE2. The decrease of the area of the second capacitor electrode CE2 due to the first indented portion ID1 is smaller than the decrease of the area of the second capacitor electrode CE2 in which the through hole is formed. Therefore, in the case of the display panel 10 according to the embodiment described herein and the electronic apparatus 1 including the display panel 10, the holding capacitor Chold formed by the first capacitor electrode CE1 and the second capacitor electrode CE2 and/or the storage capacitor Cst formed by the second capacitor electrode CE2 and the third capacitor electrode CE3 may have sufficiently large capacitance, and thus the display panel 10 and the electronic apparatus 1 are able to display high-quality images.

In some cases, if the second capacitor electrode CE2 has the through hole inside the second capacitor electrode CE2 and the connection electrode 127 is connected to the first capacitor electrode CE1 through the contact hole located within the through hole of the second capacitor electrode CE2, the length of the connection electrode 127 inevitably becomes longer. The increase of the length of the connection electrode 127 results in the increase of the area of the connection electrode 127, and thus the connection electrode 127 becomes more electrically influenced by the data line DL, or the like adjacent to the connection electrode 127.

The electric potential of the gate electrode of the first transistor T1 which is the driving transistor, i.e., the electric potential of the first capacitor electrode CE1 which is the second node N2, is the electric potential related to the brightness of light to be emitted from the organic light-emitting diode OLED, which is the display element. As described herein, embodiments of the present disclosure support minimizing external influence on the electric potential of the second node N2 during the emission period.

In the case of the display panel 10 according to the embodiment described herein and the electronic apparatus 1 having the display panel 10, the second capacitor electrode CE2 does not have the through hole but has the first indented portion ID1 at a side of the second capacitor electrode CE2. It is sufficient for the connection electrode 127 to extend to the first indented portion ID1 at a side of the second capacitor electrode CE2, without extending to the center of the second capacitor electrode CE2. Accordingly, the length of the connection electrode 127 may be decreased. The decrease of the length of the connection electrode 127 results in the decrease of the area of the connection electrode 127, and thus the connection electrode 127 becomes less electrically influenced by the data line DL, and the like, adjacent to the connection electrode 127. Therefore, the display panel 10 according to an embodiment and the electronic apparatus 1 including the display panel 10 are able to display high-quality images.

Meanwhile, as described herein, the third capacitor electrode CE3 may be interposed between the second capacitor electrode CE2 and the source-drain layer SD. The third capacitor electrode CE3 may be disposed over the second capacitor electrode CE2 such that the third capacitor electrode CE3 overlaps the second capacitor electrode CE2 when viewed in the direction perpendicular to the substrate 100 (z-axis direction). Because the connection electrode 127 is disposed on the interlayer insulating layer 109 covering the third capacitor electrode CE3, the third capacitor electrode CE3 may have a second indented portion ID2 which is indented (or recessed) inward at a side of the third capacitor electrode CE3 and exposes the first indented portion ID1. Accordingly, the connection electrode 127 may be connected to the first capacitor electrode CE1 through the contact hole 65 located in the first indented portion ID1 and the second indented portion ID2. When viewed in the direction perpendicular to the substrate 100 (z-axis direction), the first indented portion ID1 may be located within the second indented portion ID2.

As described herein, the connection electrode 125 may be connected to the second capacitor electrode CE2 through the contact hole 63 defined in the insulating layers below the connection electrode 125. To this end, as illustrated in FIG. 14, when viewed in the direction perpendicular to the substrate 100 (i.e., in the plan view), the third capacitor electrode CE3 may have not only the second indented portion ID2 at a side of the third capacitor electrode CE3 but also a third indented portion ID3 at the other side of the third capacitor electrode CE3 which is indented (or recessed) inwardly and exposes a portion of the second capacitor electrode CE2. Accordingly, the connection electrode 125 may be connected to the second capacitor electrode CE2 through the contact hole 63 located in the third indented portion ID3.

In the case of the display panel 10 according to the embodiment described herein and the electronic apparatus 1 including the display panel 10, it is sufficient for the connection electrode 125 to extend to (without extending beyond) the third indented portion ID3 at another side of the third capacitor electrode CE3. Accordingly, the length of the connection electrode 125 may be decreased. The decrease of the length of the connection electrode 125 results in the decrease of the area of the connection electrode 125, and thus the connection electrode 125 becomes less electrically influenced by the data line DL, and the like, adjacent to the connection electrode 125. Therefore, the display panel 10 according to an embodiment and the electronic apparatus 1 including the display panel 10 are able to display high-quality images.

Meanwhile, when viewed in the direction perpendicular to the substrate 100 (z-axis direction), the first capacitor electrode CE1 described herein may have a first protrusion PT1 which protrudes outside the first indented portion ID1 (i.e., in the -y direction) at the portion of the first capacitor electrode CE1 exposed by the first indented portion ID1. As illustrated in FIG. 17 which is the cross-sectional view schematically illustrating the display module 11, the first protrusion PT1 may extend in the direction to the second semiconductor layer ACT2. If the first protrusion PT1 does not exist, the second gate insulating layer 105 and the third gate insulating layer 107 disposed over the first capacitor electrode CE1 may be bent, and accordingly, the connection electrode 127 disposed over the third gate insulating layer 107 may be bent more, and thus a defect such as, for example, a short circuit may occur in the connection electrode 127. However, in the case of the display panel 10 according to the embodiment described herein and the electronic apparatus 1 including the display panel 10, the first capacitor electrode CE1 has the first protrusion PT1 which protrudes outside the first indented portion ID1 at the portion of the first capacitor electrode CE1 exposed by the first indented portion ID1, embodiments of the present disclosure may prevent or minimize the occurrence of such a defect. For reference, when viewed in the direction perpendicular to the substrate 100 (z-axis direction), the connection electrode 127 may overlap the first protrusion PT1 and may extend in a direction away from the first indented portion ID1 (-y direction).

Similarly, the second capacitor electrode CE2 may have a second protrusion PT2 which protrudes outside the third indented portion ID3 (i.e., in the +y direction) at the portion of the second capacitor electrode CE2 exposed by the third indented portion ID3. As illustrated in FIG. 17 which is the cross-sectional view schematically illustrating the display module 11, the second protrusion PT2 may extend in the direction to the first semiconductor layer ACT1. If the second protrusion PT2 does not exist, the third gate insulating layer 107 and the interlayer insulating layer 109 disposed over the second capacitor electrode CE2 may be bent, and accordingly, the connection electrode 125 disposed over the interlayer insulating layer 109 may be bent more, and thus a defect such as, for example, a short circuit may occur in the connection electrode 125. However, in the case of the display panel 10 according to the embodiment described herein and the electronic apparatus 1 including the display panel 10, the second capacitor electrode CE2 has the second protrusion PT2 which protrudes outside the third indented portion ID3 at the portion of the second capacitor electrode CE2 exposed by the third indented portion ID3, embodiments of the present disclosure may prevent or minimize the occurrence of such a defect. For reference, when viewed in the direction perpendicular to the substrate 100 (z-axis direction), the connection electrode 125 may overlap the second protrusion PT2 and may extend in a direction away from the third indented portion ID3 (+y direction).

The connection electrode 129 may be connected to the second-2 scan line GCL2 through a contact hole 69 defined in the insulating layer below the connection electrode 129, and may be connected to the second gate electrode portion GEP2 through a contact hole 71 defined in the insulating layers below the connection electrode 129. The connection electrode 131 may be connected to the third scan line GIL through a contact hole 73 defined in the insulating layer below the connection electrode 131, and may be connected to the third gate electrode portion GEP3 through a contact hole 75 defined in the insulating layers below the connection electrode 131.

The connection electrode 133 may be connected to the second semiconductor layer ACT2 through a contact hole 77 defined in the insulating layers below the connection electrode 133, and may be connected to the first initialization voltage line VIL through a contact hole 79 defined in the insulating layers below the connection electrode 133. Accordingly, the first initialization voltage VINT from the first initialization voltage line VIL may be applied to the first region of the fourth transistor T4 which is the first initialization transistor.

The connection electrode 135 may be connected to the emission control line EL through a contact hole 81 defined in the insulating layer below the connection electrode 135, and may be connected to the fourth gate electrode portion GEP4 through a contact hole 83 defined in the insulating layers below the connection electrode 135.

The connection electrode 137 in the first pixel PX1 may be electrically connected to a line different from a line to which the connection electrodes 137 in the second pixel PX2 and the third pixel PX3 are electrically connected. In each of the first pixel PX1, the second pixel PX2, and the third pixel PX3, the connection electrode 137 is connected to the second semiconductor layer ACT2 through a contact hole 84 defined in the insulating layers below the connection electrode 137. In the first pixel PX1, the connection electrode 137 may be connected to the second-1 initialization voltage line VL1 through a contact hole 85 defined in the insulating layers below the connection electrode 137. In each of the second pixel PX2 and the third pixel PX3, the connection electrode 137 may be connected to the second-2 initialization voltage line VL2 through the contact hole 85 defined in the insulating layers below the connection electrode 137. Accordingly, the second initialization voltage VAINT from the second-1 initialization voltage line VL1 may be applied to the first region of the seventh transistor T7 which is the second initialization transistor of the first pixel PX1, and the second initialization voltage VAINT from the second-2 initialization voltage line VL2 may be applied to the first region of the seventh transistor T7 which is the second initialization transistor of each of the second pixel PX2 and the third pixel PX3.

The connection electrode 138 may be connected to the second semiconductor layer ACT2 through a contact hole 86 defined in the insulating layers below the connection electrode 138, and may be connected to the bias voltage line VOBSL through a contact hole 87 defined in the insulating layers below the connection electrode 138. Accordingly, the bias voltage VOBS from the bias voltage line VOBSL may be applied to the first region of the ninth transistor T9 which is the bias transistor. The connection electrode 138 may exist in the first pixel PX1 and the third pixel PX3, and not in the second pixel PX2. However, as illustrated in FIG. 11, because the first region of the ninth transistor T9 of the first pixel PX1 and the first region of the ninth transistor T9 of the second pixel PX2 are positioned adjacent to each other and are integrally formed as a single indivisible body, the bias voltage VOBS from the bias voltage line VOBSL may also be applied to the first region of the ninth transistor T9 of the second pixel PX2.

The connection electrode 139 may be connected to the second semiconductor layer ACT2 through a contact hole 88 defined in the insulating layers below the connection electrode 139. Specifically, the connection electrode 139 may be connected to the second region of the sixth transistor T6 through the contact hole 88. The connection electrode 139 may be connected to the corresponding pixel electrode through a contact hole 99 defined in the insulating layer over the connection electrode 139. Specifically, the connection electrode 139 of the first pixel PX1 may be connected to the first pixel electrode PE1 through the contact hole 99 defined in the insulating layer over the connection electrode 139, the connection electrode 139 of the second pixel PX2 may be connected to the second pixel electrode PE2 through the contact hole 99 defined in the insulating layer over the connection electrode 139, and the connection electrode 139 of the third pixel PX3 may be connected to the third pixel electrode PE3 through the contact hole 99 defined in the insulating layer over the connection electrode 139.

The connection electrode 140 may arranged in the third pixel PX3, without being arranged in the first pixel PX1 and the second pixel PX2. The connection electrode 140 may electrically connect the fifth gate electrode portions GEP5 which are spaced apart from each other through a contact hole 96 and a contact hole 97 defined in the insulating layers below the connection electrode 140. Accordingly, a set of the electrically connected fifth gate electrode portions GEP5 and the connection electrodes 140 may form a conductive line extending approximately in the first direction (x-axis direction) and functioning as the fourth scan line GBL which may transmit the fourth scan signal GB.

The common line CL extending approximately in the second direction (y-axis direction) may be electrically connected to a line which extends approximately in the first direction (x-axis direction) and has a positive voltage. FIG. 13 and FIG. 15 show that the common line CL is connected to the second-1 initialization voltage line VL1 through a contact hole 98 defined in the insulating layers below the common line CL. Accordingly, a set of common lines CL and second-1 initialization voltage lines VL1 may have a mesh shape in the display area DA, which may prevent or minimize voltage drops, i.e., IR drop, in the second-1 initialization voltage line VL1. This common line CL may be located between the second data line DL2 and the third data line DL3, and may be located at the boundary between the second pixel PX2 and the third pixel PX3. Accordingly, it is also possible to prevent or minimize electrical interference between the second data line DL2 and the third data line DL3.

In one or more embodiments, the common line CL located in a column other than the column illustrated in FIG. 15 may be electrically connected to a line of a constant voltage other than the second-1 initialization voltage line VL1, unlike the common line CL illustrated in FIG. 15. For example, the common line CL located in the column other than the column illustrated in FIG. 15 may be connected to the second-2 initialization voltage line VL2 through a contact hole defined in the insulating layer below the common line CL. The common line CL located in another column may be connected to the first initialization voltage line VIL through a contact hole defined in the insulating layers below the common line CL. The common line CL located in another column may be connected to the bias voltage line VOBSL through a contact hole defined in the insulating layers below the common line CL. In some columns, the common line CL may be omitted.

The second reference voltage line VRL2 may be connected to the first reference voltage line VRL1 through a contact hole 89 defined in the insulating layer below the second reference voltage line VRL2, and may be connected to the first semiconductor layer ACT1 through a contact hole 90 defined in the insulating layers below the second reference voltage line VRL2, such that the reference voltage VREF may be applied to the first region of the fifth transistor T5 which is the reference voltage transistor. A set of the first reference voltage lines VRL1 and the second reference voltage lines VRL2 electrically connected to each other may have a mesh shape in the display area DA, which may prevent or minimize voltage drops, i.e., IR drop, in the reference voltage line VRL.

The power line PL may be connected to the second semiconductor layer ACT2 through a contact hole 91 defined in the insulating layers below the power line PL to transmit the driving voltage ELVDD to the first region of the tenth transistor T10, may be connected to the third capacitor electrode CE3 through a contact hole 92 defined in the insulating layer below the power line PL to transmit the driving voltage ELVDD to the third capacitor electrode CE3, may electrically connect the power connection lines PCL which are spaced apart from each other through a contact hole 93 and a contact hole 94 defined in the insulating layers below the power line PL, and may be connected to the second semiconductor layer ACT2 through a contact hole 95 defined in the insulating layers below the power line PL to transmit the driving voltage ELVDD to the first region of the eighth transistor T8.

The power line PL may have a prong as illustrated in FIG. 15. In the first pixel PX1, the prong may extend, for example, between the first data line DL1 and the connection electrode 125, and may also extend between the first data line DL1 and the connection electrode 127. This may also apply to the second pixel PX2 and the third pixel PX3. For reference, the connection electrode 127 and the power line PL may include a same material and may be disposed on a same insulating layer. For reference, the connection electrode 125 and the connection electrode 127 may be disposed on a same insulating layer.

The connection electrode 125 may correspond to the first node N1, and the connection electrode 127 may correspond to the second node N2. As described herein, the electric potential of each of the first node N1 and the second node N2 may be an electric potential related to the brightness of light to be emitted from the organic light-emitting diode OLED, which is the display element. Therefore, as described herein, embodiments of the present disclosure support minimizing external influence on the electric potential of each of the connection electrode 125 which is the first node N1 and the connection electrode 127 which is the second node N2, during the emission period.

In the case of the display panel 10 according to the embodiment described herein and the electronic apparatus 1 including the display panel 10, the power line PL having the constant driving voltage ELVDD has the prong, and the prong may extend between the data line DL and the connection electrode 125, and may also extend between the data line DL and the connection electrode 127. Therefore, during the emission period, embodiments of the present disclosure may prevent or minimize the influence from the data line DL on the electric potential of each of the connection electrode 125 which is the first node N1 and the connection electrode 127 which is the second node N2.

The source-drain layer SD may include metal, an alloy, a conductive metal oxide, or a transparent conductive material and the like. As an example, the source-drain layer SD may include silver (Ag), an alloy containing silver, molybdenum (Mo), an alloy containing molybdenum, aluminum (Al), an alloy containing aluminum, aluminum nitride (AIN), tungsten (W ), tungsten nitride (WN), copper (Cu), nickel (Ni), chrome (Cr), chrome nitride (CrN), titanium (Ti), tantalum (Ta), platinum (Pt), scandium (Sc), indium tin oxide (ITO) or indium zinc oxide (IZO), and the like. The source-drain layer SD may have a multi-layered structure. For example, the source-drain layer SD may have a two-layered structure of Ti/Al or a three-layered structure of Ti/Al/Ti.

Meanwhile, when viewed in the direction perpendicular to the substrate 100 (z-axis direction), the second capacitor electrode CE2 may have a third protrusion PT3 as illustrated in FIG. 13, and the third capacitor electrode CE3 may have a fourth protrusion PT4 as illustrated in FIG. 14, such that the fourth protrusion PT4 may overlap the third protrusion PT3. The data line DL contacts the first semiconductor layer ACT1 through the contact hole 51. A portion of the first semiconductor layer ACT1 which contacts the data line DL may be referred to as a first portion P1. The connection electrode 125 contacts the first semiconductor layer ACT1 through the contact hole 61. A portion of the first semiconductor layer ACT1 which contacts the connection electrode 125 may be referred to as a second portion P2. The third protrusion PT3 of the second capacitor electrode CE2 may protrude between the first portion P1 and the second portion P2.

As described herein, the second transistor T2 which is the switching transistor may receive the data signal from the data line DL in the first region of the second transistor T2 and transmit the data signal to the first node N1 through the second region of the second transistor T2 in response to the first scan signal. The first node N1 may be the connection electrode 125 as described herein, and the second portion P2 connected to the connection electrode 125 may also be referred to as the first node N1. The electric potential of the first node N1 is related to the brightness of light to be emitted from the organic light-emitting diode OLED which is the display element. Therefore, as described herein, embodiments of the present disclosure support minimizing external influence on the electric potential of the second portion P2 which is the first node N1, during the emission period.

The first data line DL1 transmits the data signal to the first pixel PX1 in the row illustrated in FIG. 15, and also transmits the data signal to pixels located in other rows of the same column during the emission period of the first pixel PX1. Because the first portion P1 of the first semiconductor layer ACT1 is electrically connected to the first data line DL1, and the like, the data signal is transmitted to the first portion P1. If the electric potential of the second portion P2 of the first pixel PX1, which is the first node N1 of the first pixel PX1, is electrically affected by the first portion P1 of the first pixel PX1 connected to the first data line DL1 which transmits data signal to the pixels located in other rows of the same column, the brightness of light emitted from the organic light-emitting diode OLED, which is the display element of the first pixel PX1, may become a brightness other than the initially intended brightness. This may cause a deterioration in the quality of images displayed by the display panel 10. Therefore, as described herein, embodiments of the present disclosure support minimizing the electrical influence on the second portion P2 of the first pixel PX1 from the first portion P1 of the first pixel PX1, during the emission period of the first pixel PX1. This may also apply to the second pixel PX2 and the third pixel PX3.

In the case of the display panel 10 according to the embodiment described herein and the electronic apparatus 1 including the display panel 10, the second capacitor electrode CE2 may have the third protrusion PT3, and the third capacitor electrode CE3 may have the fourth protrusion PT4 which protrudes and overlaps the third protrusion PT3. When viewed in the direction perpendicular to the substrate 100 (z-axis direction), the third protrusion PT3 protrudes between the first portion P1 and the second portion P2 of the first semiconductor layer ACT1, and the fourth protrusion PT4 also protrudes between the first portion P1 and the second portion P2 of the first semiconductor layer ACT1. Therefore, embodiments of the present disclosure may prevent or minimize the second portion P2 from being electrically influenced by the first portion P1 during the emission period of the first pixel PX1. Accordingly, the display panel 10 displaying high-quality images, and the electronic apparatus 1 including the display panel 10 may be implemented.

In particular, as described herein, the power line PL which transmits the driving voltage ELVDD is connected to the third capacitor electrode CE3 through the contact holes 92. Therefore, the electric potential of the fourth protrusion PT4 of the third capacitor electrode CE3 may be the driving voltage ELVDD. Therefore, embodiments of the present disclosure may effectively prevent or minimize the second portion P2 from being electrically influenced by the first portion P1 during the emission period of the first pixel PX1.

Meanwhile, the source-drain layer SD as illustrated in FIG. 15 is formed by forming a conductive layer which covers the interlayer insulating layer 109 and patterning the conductive layer. The source-drain layer SD may have a Ti/Al/Ti structure, i.e., the source-drain layer SD may have a Ti film, an Al film, and a Ti film which are sequentially stacked. During patterning the conductive layer having the Ti/Al/Ti structure to form the source-drain layer SD, a Ti residual film may remain on an uneven surface of the underlying interlayer insulating layer 109. The shape of the uneven surface of the interlayer insulating layer 109 may be determined by the layers below the interlayer insulating layer 109. For example, the interlayer insulating layer 109 may have an uneven surface along the edge of the element included in the third gate layer GTL3. Accordingly, the interlayer insulating layer 109 may have an uneven surface along the edge of the third capacitor electrode CE3. If the third capacitor electrode CE3 does not have the fourth protrusion PT4, the Ti residual film may exist in a shape extending in the first direction (x-axis direction) along the edge of the third capacitor electrode CE3. The Ti residual film may cause a problem such that the data line DL and the power line PL are electrically connected to each other.

In the case of the display panel 10 according to the embodiment described herein and the electronic apparatus 1 including the display panel 10, the third capacitor electrode CE3 has the fourth protrusion PT4. Because the edge of the third capacitor electrode CE3 is bent from the first direction (x-axis direction) to the second direction (y-axis direction) near the fourth protrusion PT4, the Ti residual film which may be formed along the edge of the third capacitor electrode CE3 may be disconnected at such a bent portion. Therefore, embodiments of the present disclosure may prevent or minimize the erroneous electrical connection between the data line DL and the power line PL. The third protrusion PT3 of the second capacitor electrode CE2 disposed below the fourth protrusion PT4 may also play a role similar to the role of the fourth protrusion PT4.

The planarization layer 115 (see FIG. 17) may cover the source-drain layer SD and may be disposed over the interlayer insulating layer 109. The planarization layer 115 may include an organic insulating material. For example, the planarization layer 115 may include a photoresist, benzocyclobutene (BCB), polyimide, hexamethyldisiloxane (HMDSO), polymethylmethacrylate (PMMA), polystyrene, polymer derivatives having a phenol-based group, an acryl-based polymer, an imide-based polymer, an aryl ether-based polymer, an amide-based polymer, a fluorine-based polymer, a p-xylene-based polymer, a vinyl alcohol-based polymer, or a mixture thereof. An upper surface of the planarization layer 115 may be approximately flat.

A pixel electrode layer PXL illustrated in FIG. 16 may be disposed over the planarization layer 115. The pixel electrode layer PXL may include the first pixel electrode PE1 of the organic light-emitting diode OLED of the first pixel PX1, the second pixel electrode PE2 of the organic light-emitting diode OLED of the second pixel PX2, and the third pixel electrode PE3 of the organic light-emitting diode OLED of the third pixel PX3.

As described herein, the first pixel electrode PE1 may be connected to the connection electrode 139 of the first pixel PX1 through the contact hole 99 defined in the insulating layer below the first pixel electrode PE1. This may also apply to the second pixel electrode PE2 and the third pixel electrode PE3.

The location of the first pixel electrode PE1 is not limited within the first pixel PX1. As illustrated in FIG. 16, the first pixel electrode PE1 may be located across the first pixel PX1 and the second pixel PX2. The second pixel electrode PE2 may also be located across the first pixel PX1 and the second pixel PX2. The third pixel electrode PE3 may be located across the second pixel PX2 and the third pixel PX3. In some aspects, the first pixel electrodes PE1 and the second pixel electrodes PE2 may be located in the same column, and the first pixel electrodes PE1 and the second pixel electrodes PE2 may be located alternately in the same column. The columns where the first pixel electrodes PE1 and the second pixel electrodes PE2 are located and the columns where the third pixel electrodes PE3 are located may be positioned alternately in the first direction (x-axis direction).

The first pixel electrode PE1, the second pixel electrode PE2, and the third pixel electrode PE3 may be a (semi) light-transmissive conductive layer or a reflective conductive layer. For example, each of the first pixel electrode PE1, the second pixel electrode PE2, and the third pixel electrode PE3 may include a reflective layer and a transparent or semi-transparent electrode layer on the reflective layer, and the reflective layer may include Ag, Mg, Al, Pt, Pd, Au, Ni, Nd, Ir, Cr, or compound thereof. The transparent or semitransparent electrode layer may include at least one selected from the group consisting of indium tin oxide (ITO), indium zinc oxide (IZO), zinc oxide (ZnOx: ZnO or ZnO₂), indium oxide (In₂O₃), indium gallium oxide (IGO), and aluminum zinc oxide (AZO). For example, each of the first pixel electrode PE1, the second pixel electrode PE2, and the third pixel electrode PE3 may have a three-layered structure of ITO/Ag/ITO.

A pixel-defining layer 119 (see FIG. 17) may be disposed on the planarization layer 115 and cover the edge of each of the first pixel electrode PE1, the second pixel electrode PE2, and the third pixel electrode PE3. The pixel-defining layer 119 may define a pixel by including an opening corresponding to an emission area of each pixel. The pixel-defining layer 119 may be referred to herein as a pixel definition film. FIG. 16 illustrates a first light-emitting area EA1 which is an exposed portion of the first pixel electrode PE1 without being covered by the pixel-defining layer 119, a second light-emitting area EA2 which is an exposed portion of the second pixel electrode PE2 without being covered by the pixel-defining layer 119, and a third light-emitting area EA3 which is an exposed portion of the third pixel electrode PE3 without being covered by the pixel-defining layer 119, by dotted lines.

An emission layer may be disposed in the opening of the pixel-defining layer 119, and the common electrode CME may be disposed over the emission layer. The first pixel electrode PE1, the second pixel electrode PE2, the third pixel electrode PE3, the emission layer, and the common electrode CME may configure organic light-emitting diodes OLEDs. The common electrode CME may be integrally formed as a single unitary indivisible body throughout the plurality of organic light-emitting diodes OLEDs to correspond to the plurality of pixel electrodes in the display area DA.

A first intermediate layer may be interposed between the first pixel electrode PE1 and the common electrode CME, a second intermediate layer may be interposed between the second pixel electrode PE2 and the common electrode CME, and a third intermediate layer may be interposed between the third pixel electrode PE3 and the common electrode CME. Each of the first intermediate layer, the second intermediate layer, and the third intermediate layer may include an emission layer, and the emission layer may have an isolated shape overlapping the corresponding pixel electrode. Each of layers other than the emission layer included in the first intermediate layer, the second intermediate layer, and the third intermediate layer, such as, for example, a hole transport layer, an electron transport layer, and/or an electron injection layer, may be integrally formed as a single unitary indivisible body throughout the plurality of organic light-emitting diodes OLEDs and may correspond to the plurality of pixel electrodes. In FIG. 17, the hole transport layer, the electron transport layer and/or the electron injection layer are not illustrated and are omitted for convenience.

The common electrode CME may be a light-transmissive electrode or a reflective electrode. For example, the common electrode CME may be a transparent or semi-transparent electrode and may include a thin metal film having a low work function. The common electrode CME may include at least one of Li, Ca, Al, Ag, Mg, or compound (e.g., LiF) thereof. In an embodiment, the common electrode CME may further include a transparent conductive oxide (TCO) layer such as, for example, ITO, indium zinc oxide (IZO), ZnO, ZnO₂, or In₂O₃, disposed on the thin metal film. The common electrode CME may be integrally formed as a single unitary indivisible body throughout the entire surface of the display area DA and cover the display area DA.

In one or more embodiments, an encapsulation layer may be disposed over the common electrode CME. The encapsulation layer may include a first inorganic encapsulation layer, a second inorganic encapsulation layer, and an organic encapsulation layer therebetween.

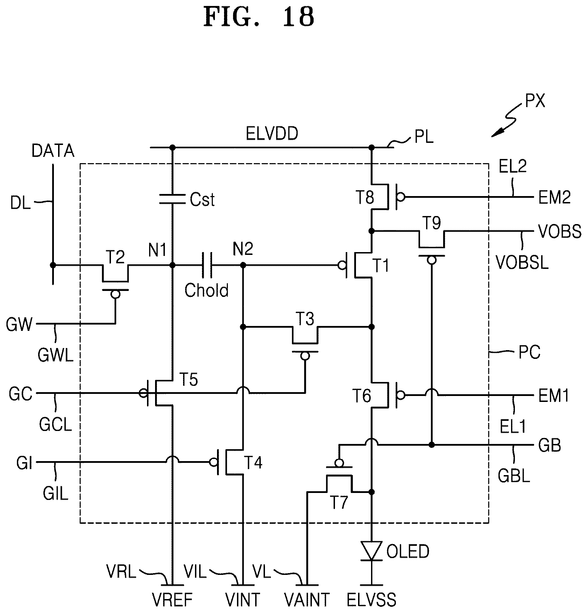

Up to this point, the description has been made to the case of the display panel 10 having the pixel circuit PC illustrated in FIG. 8 and the electronic apparatus 1 including the display panel 10. However, one or more embodiments are not limited thereto. FIG. 18 illustrates an equivalent circuit diagram of a pixel circuit PC electrically connected to a display element included in a display module 11 according to an embodiment. As illustrated in FIG. 18, the pixel circuit PC may not include the tenth transistor T10. In some aspects, a first emission control signal EM1 may be applied to the gate electrode of the sixth transistor T6 through a first emission control line EL1, and a second emission control signal EM2 may be applied to the gate electrode of the eighth transistor T8 through a second emission control line EL2.

The above-described explanation regarding the first indented portion ID1 of the second capacitor electrode CE2, the second indented portion ID2 and the third indented portion ID3 of the third capacitor electrode CE3, the first protrusion PT1 of the first capacitor electrode CE1, the second protrusion PT2 and the third protrusion PT3 of the second capacitor electrode CE2, and/or the fourth protrusion PT4 of the third capacitor electrode CE3 may also be applied to the embodiment of the display panel 10 including the pixel circuits PC illustrated in FIG. 18 and the electronic apparatus 1 including the display panel 10.

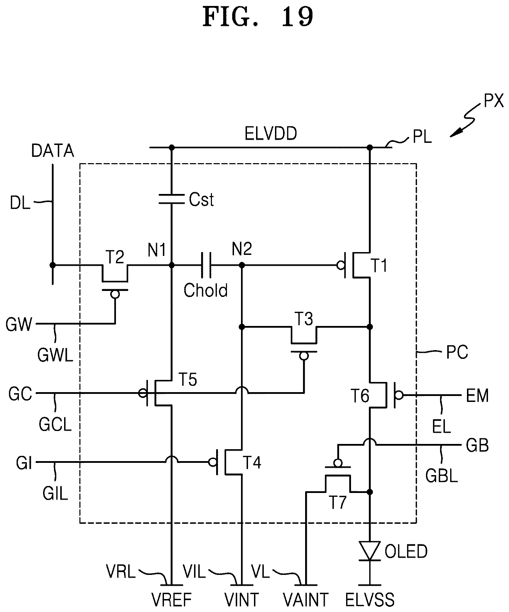

FIG. 19 illustrates an equivalent circuit diagram of a pixel circuit PC electrically connected to a display element included in a display module 11 according to an embodiment. As illustrated in FIG. 19, the pixel circuit PC may not include not only the tenth transistor T10 but also the eighth transistor T8 and the ninth transistor T9. The above-described explanation may also be applied to the embodiment of the display panel 10 including the pixel circuits PC illustrated in FIG. 19 and the electronic apparatus 1 including the display panel 10.

So far, the display panel 10 and the electronic apparatus 1 including the display panel 10 have been described as having the source-drain layer SD. However, one or more embodiments are not limited thereto. For example, the display panel 10 and the electronic apparatus 1 including the display panel 10 may include a first source-drain layer, an additional interlayer insulating layer covering the first source-drain layer, and a second source-drain layer disposed over the additional interlayer insulating layer. In this case, various modifications are possible. For example, the data line DL may be included in the first source-drain layer and the common line CL and/or power line PL may be included in the second source-drain layer.

Up to this point, the description has been mainly made to the structure of the display panel 10. However, one or more embodiments are not limited thereto. The electronic apparatus 1 including such a display panel 10 may also be said to fall within the scope of the disclosure.

As described herein, the disclosure has been described with reference to the one or more embodiments illustrated in the accompanying drawings, but should be considered in a descriptive sense. Those of ordinary skill in the art will understand that various modifications and equivalent embodiments may be made therefrom. Therefore, the true technical scope of protection of the disclosure should be defined by the technical spirit of the appended claims.

According to an embodiment, the display panel 10 that may display high-quality images and the electronic apparatus 1 including the display panel 10 may be implemented. However, the scope of the disclosure is not limited by the above effects.

It should be understood that the embodiments described herein should be considered in a descriptive sense and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the spirit and scope as defined by the following claims.

## Claims

1. A display panel (10) comprising:
a substrate (100);
a first capacitor electrode (CE1) disposed over the substrate (100);
a second capacitor electrode (CE2) which is disposed over the first capacitor electrode (CE1), overlaps the first capacitor electrode (CE1) when viewed in a direction perpendicular to the substrate (100), and has a first indented portion (ID1) which is indented inward at a side of the second capacitor electrode (CE2) and exposes a portion of the first capacitor electrode (CE1) when viewed in the direction perpendicular to the substrate (100); and
a first connection electrode disposed over the second capacitor electrode (CE2) and connected to the first capacitor electrode (CE1) through a contact located in the first indented portion (ID1).

2. The display panel (10) of claim 1, wherein the first capacitor electrode (CE1) has a first protrusion (PT1) which, when viewed in the direction perpendicular to the substrate (100), protrudes outside the first indented portion (ID1), at the portion of the first capacitor electrode (CE1) exposed by the first indented portion (ID1).

3. The display panel (10) of any of claims 1 or 2, further comprising a third capacitor electrode (CE3) which is disposed over the second capacitor electrode (CE2), overlaps the second capacitor electrode (CE2) when viewed in the direction perpendicular to the substrate (100), and has a second indented portion (ID2) which is indented inward at a side of the third capacitor electrode (CE3) and exposes the first indented portion (ID1) when viewed in the direction perpendicular to the substrate (100),
wherein the first connection electrode is disposed over the third capacitor electrode (CE3).

4. The display panel (10) of claim 3, wherein, when viewed in the direction perpendicular to the substrate (100):
each of the first capacitor electrode (CE1) and the second capacitor electrode (CE2) has an isolated shape, and
the third capacitor electrode (CE3) has a shape extending in a first direction.

5. The display panel (10) of claim 4, wherein:
each of the first capacitor electrode (CE1) and the second capacitor electrode (CE2) is located within one pixel, and
the third capacitor electrode (CE3) is integrally formed as a single body throughout a plurality of pixels.

6. The display panel (10) of claim 4, further comprising a power line (PL) disposed over the third capacitor electrode (CE3) and extending in a second direction crossing the first direction,
wherein the third capacitor electrode (CE3) and the power line (PL) are electrically connected to each other through a contact hole.

7. The display panel (10) of claim 6, wherein the first connection electrode and the power line (PL) comprise a same material and are disposed on a same insulating layer.

8. The display panel (10) of claim 3, wherein:
the third capacitor electrode (CE3) has a third indented portion (ID3) which, when viewed in the direction perpendicular to the substrate (100), is indented inward at another side of the third capacitor electrode (CE3) and exposes a portion of the second capacitor electrode (CE2), and
the display panel (10) further comprises a second connection electrode disposed over the third capacitor electrode (CE3) and connected to the second capacitor electrode (CE2) through a contact hole located in the third indented portion (ID3).

9. The display panel (10) of claim 1, further comprising:
a semiconductor layer (ACT) interposed between the substrate (100) and the first capacitor electrode (CE1) and comprising a first portion (P1) and a second portion (P2);
a data line (DL) disposed over the semiconductor layer (ACT), extending in a second direction, and electrically connected to the first portion (P1) through a contact hole; and
a second connection electrode disposed over the second capacitor electrode (CE2) and electrically connecting the second capacitor electrode (CE2) to the second portion (P2),
wherein the second capacitor electrode (CE2) comprises a third protrusion (PT3) that, when viewed in the direction perpendicular to the substrate (100), protrudes between the first portion (P1) and the second portion (P2).

10. The display panel (10) of claim 9, further comprising a third capacitor electrode (CE3) which is disposed over the second capacitor electrode (CE2), overlaps the second capacitor electrode (CE2) when viewed in the direction perpendicular to the substrate (100), and has a fourth protrusion (PT4) which protrudes and overlaps the third protrusion (PT3) when viewed in the direction perpendicular to the substrate (100).

11. The display panel (10) of claim 10, further comprising a power line (PL) disposed over the third capacitor electrode (CE3) and extending in the second direction crossing a first direction in which the third capacitor electrode (CE3) extends,
wherein the third capacitor electrode (CE3) and the power line (PL) are electrically connected to each other through a contact hole.

12. An electronic apparatus (1) comprising:
a processor (41); and
a display panel (10) controlled by the processor (41),
wherein the display panel (10) comprises:
a substrate (100);
a first capacitor electrode (CE1) disposed over the substrate (100);
a second capacitor electrode (CE2) which is disposed over the first capacitor electrode (CE1), overlaps the first capacitor electrode (CE1) when viewed in a direction perpendicular to the substrate (100), and has a first indented portion (ID1) which is indented inward at a side of the second capacitor electrode (CE2) and exposes a portion of the first capacitor electrode (CE1) when viewed in the direction perpendicular to the substrate (100); and
a first connection electrode disposed over the second capacitor electrode (CE2) and connected to the first capacitor electrode (CE1) through a contact hole located in the first indented portion (ID1).

13. The electronic apparatus (1) of claim 12, wherein the first capacitor electrode (CE1) has a first protrusion (PT1) which, when viewed in the direction perpendicular to the substrate (100), protrudes outside the first indented portion (ID1), at the portion of the first capacitor electrode (CE1) exposed by the first indented portion (ID1).

14. The electronic apparatus (1) of claim 12, further comprising:
a third capacitor electrode (CE3) which is disposed over the second capacitor electrode (CE2), overlaps the second capacitor electrode (CE2) when viewed in the direction perpendicular to the substrate (100), has a second indented (ID2) portion which is indented inward at a side of the third capacitor electrode (CE3) and exposes the first indented portion (ID1) when viewed in the direction perpendicular to the substrate (100), and has a third indented portion (ID3) which is indented inward at another side of the third capacitor electrode (CE3) and exposes a portion of the second capacitor electrode (CE2) when viewed in the direction perpendicular to the substrate (100); and
a second connection electrode disposed over the third capacitor electrode (CE3) and connected to the second capacitor electrode (CE2) through a contact hole located in the third indented portion (ID3),
wherein the first connection electrode and the second connection electrode are disposed on a same insulating layer.

15. The electronic apparatus (1) of claim 12, further comprising:
a semiconductor layer (ACT) interposed between the substrate (100) and the first capacitor electrode (CE1) and comprising a first portion (P1) and a second portion (P2);
a data line (DL) disposed over the semiconductor layer (ACT), extending in a second direction, and electrically connected to the first portion (P1) through a contact hole;
a second connection electrode disposed over the second capacitor electrode (CE2) and electrically connecting the second capacitor electrode (CE2) to the second portion (P2); and
a third capacitor electrode (CE3) disposed over the second capacitor electrode (CE2) and overlapping the second capacitor electrode (CE2) when viewed in the direction perpendicular to the substrate (100),
wherein:
the second capacitor electrode (CE2) comprises a third protrusion (PT3) that protrudes between the first portion (P1) and the second portion (P2) when viewed in the direction perpendicular to the substrate (100), and
the third capacitor electrode (CE3) comprises a fourth protrusion (PT4) which protrudes and overlaps the third protrusion (PT3) when viewed in the direction perpendicular to the substrate (100).
